(19) **Europäisches Patentamt**
**European Patent Office**
**Office européen des brevets**

(11) **EP 4 394 450 A1**

(12) **EUROPEAN PATENT APPLICATION**
published in accordance with Art. 153(4) EPC

(43) Date of publication:
**03.07.2024 Bulletin 2024/27**

(51) International Patent Classification (IPC):
$G01S\ 19/39^{(2010.01)}$     $G01S\ 19/44^{(2010.01)}$
$G06F\ 17/15^{(2006.01)}$     $G06F\ 30/20^{(2020.01)}$

(21) Application number: **22919898.1**

(22) Date of filing: **28.10.2022**

(86) International application number:
**PCT/CN2022/128156**

(87) International publication number:
**WO 2023/134264 (20.07.2023 Gazette 2023/29)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **17.01.2022 CN 202210051258**

(71) Applicant: **Tencent Technology (Shenzhen)
Company Limited
Shenzhen, Guangdong, 518057 (CN)**

(72) Inventor: **SU, Jinglan
Shenzhen, Guangdong 518057 (CN)**

(74) Representative: **Nederlandsch Octrooibureau
P.O. Box 29720
2502 LS The Hague (NL)**

(54) **ERROR MODEL DETERMINATION METHOD AND APPARATUS, ELECTRONIC DEVICE, COMPUTER READABLE STORAGE MEDIUM, AND COMPUTER PROGRAM PRODUCT**

(57)     Embodiments of this application provide an error model determining method and apparatus, an electronic device, a computer-readable storage medium, and a computer program product, which can be applied to scenarios such as maps, automated driving, and smart transportation. The method includes: obtaining observation data acquired by at least two devices to be calibrated; solving a pre-constructed observation equation according to the observation data to obtain a data residual sequence; performing grid processing on the data residual sequence to obtain a data residual grid; performing grid error processing on the data residual grid according to each data residual value in the data residual sequence to obtain a measurement error grid corresponding to the data residual grid; and performing nonlinear fitting on the measurement error grid to obtain a data error model of the at least two devices to be calibrated. Through this application, the measurement error grid that accurately reflects the law of data errors can be obtained, thereby accurately determining the data error model and achieving accurate error model calibration in various types of mobile terminals.

FIG. 3

**Description**

RELATED APPLICATION

This application is proposed based on and claims priority to Chinese Patent Application No. 202210051258.9 filed on January 17, 2022.

FIELD OF THE TECHNOLOGY

Embodiments of this application relate to the field of positioning technologies, and relate to, but are not limited to, an error model determining method and apparatus, an electronic device, a computer-readable storage medium, and a computer program product.

BACKGROUND OF THE DISCLOSURE

With the wide application of navigation technologies, the general trend currently is to provide high-precision services for real-time applications. Because there are errors between observation data acquired by a positioning device and real values, a data error model of the observation data needs to be first determined before positioning, and then data calibration is performed on the acquired observation data through the data error model.

In the related art, an error calibration algorithm for the acquired observation data is complex and requires a large amount of calculation, and it is relatively difficult to implement the algorithm in various types of mobile terminals. In addition, the error calibration algorithm and the data error model are low in universality, and cannot adapt to different observation scenarios, causing the error reliability of estimated observation data to be poor.

SUMMARY

Embodiments of this application provide an error model determining method and apparatus, an electronic device, a computer-readable storage medium, and a computer program product, which can be applied to at least scenarios such as maps, automated driving, and smart transportation. Therefore, a data error model can be accurately determined in various types of mobile terminals and observation scenarios, so that data calibration is accurately performed on the observation data based on the data error model, thereby improving universality of the data calibration.

The technical solutions in the embodiments of this application are implemented as follows:

An embodiment of this application provides an error model determining method, executable by an error model determining device and including:

obtaining observation data acquired by at least two devices to be calibrated; solving a pre-constructed observation equation according to the observation data to obtain a data residual sequence; performing grid processing on the data residual sequence to obtain a data residual grid; performing grid error processing on the data residual grid according to each data residual value in the data residual sequence to obtain a measurement error grid corresponding to the data residual grid; and performing nonlinear fitting on the measurement error grid to obtain a data error model of the at least two devices to be calibrated.

An embodiment of this application provides an error model determining apparatus, including:

a solver module, configured to obtain observation data acquired by at least two devices to be calibrated, and solve a pre-constructed observation equation according to the observation data to obtain a data residual sequence; a grid processing module, configured to perform grid processing on the data residual sequence to obtain a data residual grid; a grid error processing module, configured to perform grid error processing on the data residual grid according to each data residual value in the data residual sequence to obtain a measurement error grid corresponding to the data residual grid; and a nonlinear fitting module, configured to perform nonlinear fitting on the measurement error grid to obtain a data error model of the at least two devices to be calibrated.

An embodiment of this application provides an electronic device, including: a memory, configured to store executable instructions; and a processor, configured to execute the executable instructions stored in the memory to implement the error model determining method described above.

An embodiment of this application provides a computer program product, including executable instructions, the executable instructions being stored in a computer-readable storage medium. A processor of an electronic device reads the executable instructions from the computer-readable storage medium. The processor is configured to execute the executable instructions to implement the error model determining method described above.

An embodiment of this application provides a computer-readable storage medium, storing executable instructions, and configured to cause a processor to execute the executable instructions to implement the error model determining method described above.

The embodiments of this application have the following beneficial effects: A pre-constructed observation equation is solved according to observation data acquired by at least two devices to be calibrated to obtain a data residual sequence. Then, grid processing is performed on the data residual sequence, and further, grid error processing is performed on a data residual grid according to each data residual value in the data residual sequence to determine a measurement error grid corresponding to the data residual grid. Nonlinear fitting is performed on the measurement error grid to correspondingly obtain a data error model, thereby achieving the calibration of the data error model of the at least two devices to be calibrated. In the embodiments of this application, the grid error processing is performed on the data residual grid based on the each data residual value in the data residual sequence to obtain the measurement error grid that can truly reflect the law of data errors. Therefore, the data error model can be accurately determined based on the measurement error grid. In addition, the method of the embodiments of this application can determine data error models in various types of mobile terminals and observation scenarios, so that acquired observation data is calibrated according to the determined data error models, thereby improving universality of data calibration.

BRIEF DESCRIPTION OF THE DRAWINGS

FIG. 1A is an optional schematic architectural diagram of an error model determining system according to an embodiment of this application.

FIG. 1B is a schematic diagram showing that a device to be calibrated acquires observation data according to an embodiment of this application.

FIG. 2 is a schematic structural diagram of an error model determining device according to an embodiment of this application.

FIG. 3 is an optional schematic flowchart of an error model determining method according to an embodiment of this application.

FIG. 4 is another optional schematic flowchart of an error model determining method according to an embodiment of this application.

FIG. 5 is still another optional schematic flowchart of an error model determining method according to an embodiment of this application.

FIG. 6 is a schematic flowchart of a determining procedure of an error model determining method according to an embodiment of this application.

FIG. 7 is a schematic flowchart of a determining procedure of a pseudorange and a carrier phase observation random error model according to an embodiment of this application.

FIG. 8 is a schematic diagram of a grid of carrier-to-noise ratios CNO and altitude angles according to an embodiment of this application.

FIG. 9 is a schematic diagram of grids of GPS, GLONASS, GALILEO, and BDS systems according to an embodiment of this application.

FIG. 10 is a schematic flowchart of a determining procedure of a doppler observation random error model according to an embodiment of this application.

DESCRIPTION OF EMBODIMENTS

To make the objectives, technical solutions, and advantages of this application clearer, the following describes this application in further detail with reference to the accompanying drawings. The described embodiments are not to be considered as a limitation to this application. All other embodiments obtained by a person of ordinary skill in the art without creative efforts shall fall within the protection scope of this application.
In the following description, the term "some embodiments" describes subsets of all possible embodiments, but it may be understood that "some embodiments" may be the same subset or different subsets of all the possible embodiments, and can be combined with each other without conflict. Unless otherwise defined, meanings of all technical and scientific terms used in the embodiments of this application are the same as those usually understood by a person skilled in the technical field to which the embodiments of this application belong. Terms used in the embodiments of this application are merely intended to describe objectives of the embodiments of this application, and are not intended to limit this application.

Before describing the solutions of the embodiments of this application, it first needs to explain that A satellite positioning scenario of the embodiments of this application can be used at least for achieving a vehicle positioning field or a navigation field.

Terms involved in the embodiments of this application are explained as follows:

(1) Navigation system: is a space-based radio navigation and positioning system that can provide users with all-weather three-dimensional coordinates and speed and time information at any location on the surface of the earth or in a near earth space. Common systems include four major systems: Global Positioning System (GPS), BeiDou Navigation Satellite System (BDS), Global Navigation Satellite System (GLONASS), and Galileo Satellite Navigation System (GALILEO).

(2) Mobile terminal: or mobile communication terminal, refers to a computer device that can be used on the move, including a mobile phone, a notebook, a tablet, a POS machine, or even a vehicle-mounted computer. With the rapid development of integrated circuit technology, processing capabilities of mobile terminals have become powerful. In addition, the mobile terminal integrates a navigation system positioning chip, used for processing satellite signals and performing precise positioning of users, which has been widely used in location services.

(3) Positioning device: is an electronic device used for processing satellite signals and measuring a geometric distance (pseudorange observation value) between the device and the satellite, a doppler effect of the satellite signal (doppler observation value), and a carrier phase. The positioning device usually includes at least antennas, baseband signal processing modules, and the like. A mobile terminal integrating the positioning device calculates current location coordinates of the mobile terminal based on pseudorange and doppler observation values. Positioning devices are widely used in map navigation, surveying, location services, and other fields, such as smartphone map navigation and high-precision geodesy.

(4) Observation value: refers to observation values output by the positioning device, including parameters such as a pseudorange observation value, a pseudorange rate, and an accumulated delta range (ADR). The pseudorange measures the geometric distance from the satellite to the positioning device. The pseudorange rate measures the doppler effect produced by the relative motion of the positioning device and the satellite. The ADR measures a change in the geometric distance from the satellite to the positioning device.

(5) Pseudorange observation value: refers to an approximate distance between a signal receiver (for example, the positioning device) and the satellite during the positioning process.

(6) Doppler observation value: can be understood as a doppler measurement or a doppler count of radio signals sent by satellites and measured by a signal receiver.

(7) Epoch: refers to an observation moment of a signal receiver.

(8) Carrier-to-noise ratio is a standard measurement scale used for expressing a relationship between a carrier and carrier noise.

(9) Altitude angle is an angle between a horizontal plane and a direction line from a point at which the signal receiver is located to the satellite.

(10) Positioning device measurement error model (that is, data error model): Due to a multipath effect, receiver measurement noise, and so on, there are measurement errors in pseudorange, carrier phase, and doppler observation values obtained by the positioning device. The positioning device measurement error model represents a function relation of statistical characteristics (a variance and a standard deviation) of positioning device measurement errors with respect to factors such as a signal carrier-to-noise ratio and an altitude angle.

Before an error model determining method in the embodiments of this application is explained, the method in the related art is first described.

Because there are errors between a real value and each of a pseudorange measurement value and a doppler observation value obtained by a positioning device, a data error model needs to be first determined before positioning, and the errors are calibrated by using the data error model. In the related art, technologies related to error calibration include the following:

In a first manner, first, a single-difference observation model between stars is established according to an original observation model, and a double-difference observation model between epochs is established according to the established single-difference observation model between stars. Then, a common star is selected, observation values of two adjacent epochs of the common star are obtained, and observation values of the two adjacent epochs of a receiver are obtained. Finally, observation noise is determined according to the established single-difference observation model and double-difference observation model between epochs, the obtained observation values of the two adjacent epochs of the common star, and the obtained observation values of the two adjacent epochs of the receiver.

However, this manner only uses the single-difference observation model and the double-difference observation model between epochs to obtain the receiver measurement noise, but does not establish a pseudorange error model based on the obtained receiver measurement noise sequence. This solution does not provides a relevant method for analyzing doppler observation value noise.

In a second manner, first, a BDS observation value and an observation residual after pre-adjustment are obtained, and an observation value weight ratio of different BDS orbit types is determined. Then, pseudorange observation value noise of each satellite in a current epoch is solved in real time according to an original observation value. Finally, an observation value variance matrix is solved by real-time classification by using the observation value weight ratio and a pseudorange observation value variance.

However, this manner performs variance component estimation based on a Helmert algorithm. The algorithm is complex, an amount of calculation is large, and an error model obtained through the estimation is easily affected by positioning accuracy and troposphere and ionosphere correction models, resulting in poor reliability. In addition, this solution also does not provide a relevant method for analyzing doppler observation value noise.

In a third manner, first, during positioning data processing by a Global Navigation Satellite System (GNSS), observation values and a degree of dispersion of a difference between triple-difference phase observation values between epochs are combined based on Melbourne-Wubbena (a combined observation value algorithm). Then, pseudorange noise and phase noise are estimated in real time by using a sliding window and a decay memory method. Finally, a ratio of the pseudorange noise and the phase noise is calculated as a pseudorange-phase weight ratio indicator in a positioning stochastic model, and a GNSS adaptive pseudorange-phase weight ratio is determined by using the positioning stochastic model.

However, in this manner, the pseudorange and phase noise are estimated in real time by using the sliding window and decay memory method, and the ratio of the pseudorange noise and the phase noise is calculated as the pseudorange-phase weight ratio indicator in the positioning stochastic model, to implement the determining of the GNSS adaptive pseudorange-phase weight ratio. That is, only the pseudorange-phase weight ratio is calculated but pseudorange and doppler measurement error models are not calibrated, resulting in low universality.

In a fourth manner, first, a GNSS observation value is obtained. Then, information about an altitude angle, an azimuth angle, and a carrier-to-noise ratio corresponding to each observation value is determined, and a fixed weight function of the altitude angle, the azimuth angle, and the carrier-to-noise ratio is constructed. Finally, the fixed weight function is used for constructing a random model, and GNSS navigation and positioning are achieved through the random model.

However, this manner calculates a GNSS observation value weight according to an error model given in advance, without considering differences in noise measurement by different positioning devices, resulting in poor universality.

From the foregoing implementations in the related art, it can be learned that in the related art, it is impossible to provide a pseudorange error model, a carrier phase error model, and a doppler error model at the same time for various types of mobile devices. In other words, it is difficult to implement a calibration process of the data error model in various types of mobile terminals, and the error calibration algorithm has low universality and cannot be adapted to different observation scenarios, causing an error obtained through estimation by using the data error model to be less reliable.

In view of the foregoing problem in the related art, an embodiment of this application provides an error model determining method. This method is an effective method for determining an observation random error model (that is, a data error model) by using a power splitter. A signal power splitter splits a satellite signal into two paths to two identical devices a and b to be calibrated, acquires pseudorange, carrier phase, and doppler observation data of each of the two identical devices a and b to be calibrated, constructs a zero baseline by using the acquired observation data, and performs real-time kinematic positioning (RTK) solution. Then, grid processing is performed on a pseudorange double-difference residual sequence, a carrier phase double-difference residual sequence, and a doppler single-difference residual sequence. Finally, nonlinear fitting is performed on function relations of three error standard deviations: a pseudorange measurement error standard deviation, a carrier phase measurement error standard deviation, and a doppler measurement error standard deviation, respectively with respective to a carrier-to-noise ratio and an altitude angle to obtain a data error model of at least two devices to be calibrated.

In the error model determining method provided in embodiments of the present disclosure including the embodiments of both the claims and the specification (hereinafter referred to as "all embodiments of the present disclosure", first, observation data acquired by at least two devices to be calibrated may be obtained. Then, a pre-constructed observation equation is solved according to the observation data to obtain a data residual sequence, and grid processing is performed on the data residual sequence to obtain a data residual grid. Then, grid error processing is performed on the data residual grid according to each data residual value in the data residual sequence to obtain a measurement error grid corresponding to the data residual grid. Finally, nonlinear fitting is performed on the measurement error grid to correspondingly obtain a data error model of the at least two devices to be calibrated. In this way, the data error model of the at least two devices to be calibrated is calibrated. Because the grid error processing is performed on the data residual grid based on the each data residual value in the data residual sequence to obtain the measurement error grid that can truly reflect the law of data errors, the data error model can be accurately determined. In addition, the data error model determining method can calibrate data error models in various types of mobile terminals and observation scenarios, so that universality of a process of determining a data error model is improved, thereby further improving universality of data calibration.

The following describes an exemplary application of an error model determining device of the embodiments of this application. The error model determining device is an electronic device for determining a data error model. An error model determining system provided in all embodiments of this application may include at least a device to be calibrated and an error model calibration device (that is, the error model determining device). The device to be calibrated has a determined structure and is a device for observing a target observation object and acquiring observation data. The error model calibration device may be implemented as a user terminal or may be implemented as a server. In an implementation, the error model calibration device provided in all embodiments of this application may be implemented as any terminal with a data processing function such as a notebook computer, a tablet computer, a desktop computer, a mobile device (such as a mobile phone, a portable music player, a personal digital assistant, a dedicated messaging device, or a portable game device), a smart robot, a smart home appliance, a smart speaker, a smart watch, or an in-vehicle terminal. In another implementation, the error model calibration device provided in all embodiments of this application may alternatively be implemented as a server. The server may be an independent physical server, or may be a server cluster or a distributed system including a plurality of physical servers, or may be a cloud server providing basic cloud computing services, such as a cloud service, a cloud database, cloud computing, a cloud function, cloud storage, a network service, cloud communication, a middleware service, a domain name service, a security service, a content delivery network (CDN), big data, and an artificial intelligence platform. The terminal and the server may be directly or indirectly connected in a wired or wireless communication manner. This is not limited in all embodiments of this application. When the error model calibration device of the embodiments of this application is used for determining a pseudorange error model, a carrier phase error model, and a doppler error model in a data error model, the error model calibration device may be implemented as a data processing device, such as a server or a personal computer. When the error model calibration device is used for positioning based on a pseudorange error model, a carrier phase error model, and a doppler error model, the error model calibration device may be a mobile device such as a smartphone or a vehicle-mounted navigation device. The following describes an exemplary application in which the data processing device is implemented as a server.

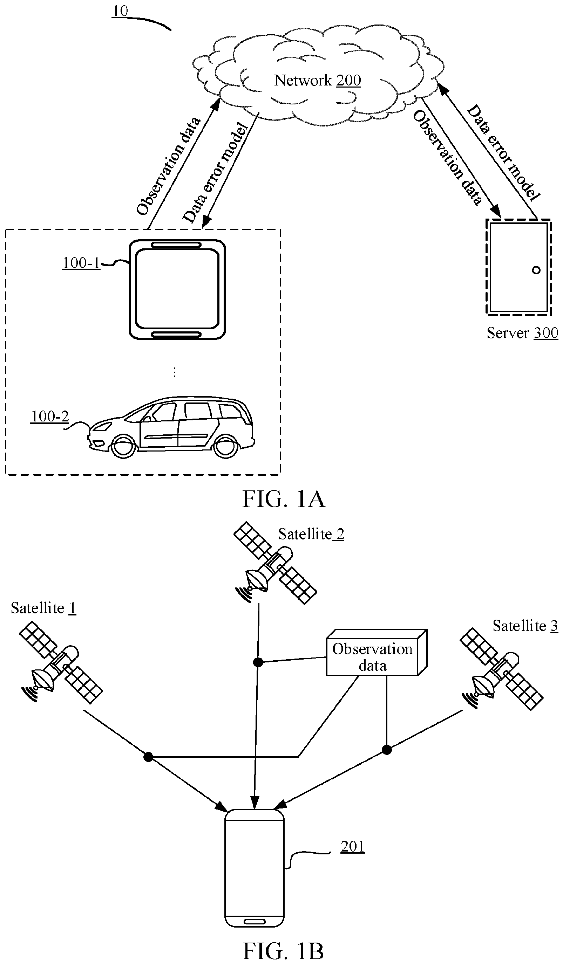

FIG. 1A is an optional schematic architectural diagram of an error model determining system 10 according to an embodiment of this application. To support an error model calibration application, an application based on a location service, or a positioning application, the error model determining system 10 provided in this embodiment of this application may include at least two devices to be calibrated (FIG. 1A exemplarily shows a device 100-1 to be calibrated and a device 100-2 to be calibrated), a network 200, and a server 300. The server 300 may constitute the error model calibration device in all embodiments of this application. The device 100-1 to be calibrated and the device 100-2 to be calibrated are connected to the server 300 through the network 200. The network 200 may be a wide area network or a local area network, or a combination of the two. The device 100-1 to be calibrated and the device 100-2 to be calibrated are each configured to observe a target observation object, acquire observation data, and transmit the observation data to the server 300 through the network 200.

In some embodiments, the error model determining system may further include a signal power splitter (not shown in the figure), configured to transmit a satellite signal in two paths to two identical devices 100-1 and 100-2 to be calibrated.

In some embodiments, the error model determining system may further include a first receiver, a second receiver, a fixing apparatus, and a fixed plate (not shown in the figure). In addition, the device 100-1 to be calibrated, the device 100-2 to be calibrated, the first receiver, and the second receiver are all fixed to the fixed plate through the fixing apparatus. A phase center of the device 100-1 to be calibrated, a phase center of the device 100-2 to be calibrated, a phase center of the first receiver, and a phase center of the second receiver all remain on the same straight line.

In this embodiment of this application, after receiving observation data acquired by at least two devices to be calibrated, the server 300 (that is, the error model calibration device) solves a pre-constructed observation equation according to the observation data to obtain a data residual sequence; then, performs grid processing on the data residual sequence to obtain a data residual grid; then, performs grid error processing on the data residual grid according to each data residual value in the data residual sequence to obtain a measurement error grid corresponding to the data residual grid; and finally, performs nonlinear fitting on the measurement error grid to correspondingly obtain a data error model of the at least two devices to be calibrated, the data error model being used for error estimation on the observation data of the at least two devices to be calibrated. After obtaining the data error model, the server 300 feeds back, through the network 200, the data error model to the device 100-1 to be calibrated and the device 100-2 to be calibrated, or the server 300 stores the data error model, so that subsequently any device to be positioned can be positioned based on the data error model.

In some embodiments, when the error model calibration device is implemented as a terminal, a positioning function can be further implemented based on the data error model, that is, a mobile device such as a smartphone or a vehicle-mounted navigation device can be accurately positioned based on the determined data error model.

FIG. 1B is a schematic diagram showing that a device to be calibrated acquires observation data according to an embodiment of this application. As shown in FIG. 1B, any device 201 to be calibrated can receive signals from different satellites, such as satellite 1, satellite 2, and satellite 3 shown in FIG. 1B, to obtain observation data. The observation data includes, but is not limited to, pseudorange observation data, carrier phase observation data, and doppler observation data of each epoch.

The error model determining method provided in all embodiments of this application may alternatively be implemented through a cloud technology based on a cloud platform. For example, the server 300 may be a cloud server. The pre-constructed observation equation is solved through the cloud server according to the observation data, grid processing is performed on the data residual sequence, and nonlinear fitting is performed on the measurement error grid. In some embodiments, there also may be a cloud memory, and the obtained data error model may be stored in the cloud memory, for subsequent use during positioning.

The cloud technology is a hosting technology that unifies a series of resources such as hardware, software, and networks within a wide area network or a local area network to implement data calculation, storage, processing, and sharing. The cloud technology is a general term for network technology, information technology, integration technology, management platform technology, and application technology that are applied based on cloud computing modes, and can constitute a resource pool to be used as required, which is flexible and convenient. Cloud computing technology is to become an important support. Backend services of a technology network system require a large amount of computing and storage resources, such as video websites, image-based websites, and more portal websites. With the rapid development and application of the Internet industry, in the future, each item may have its own identification mark, which needs to be transmitted to the backend system for logical processing. Data at different levels will be processed separately, and all types of industry data require strong system backing support, which can be achieved through cloud computing.

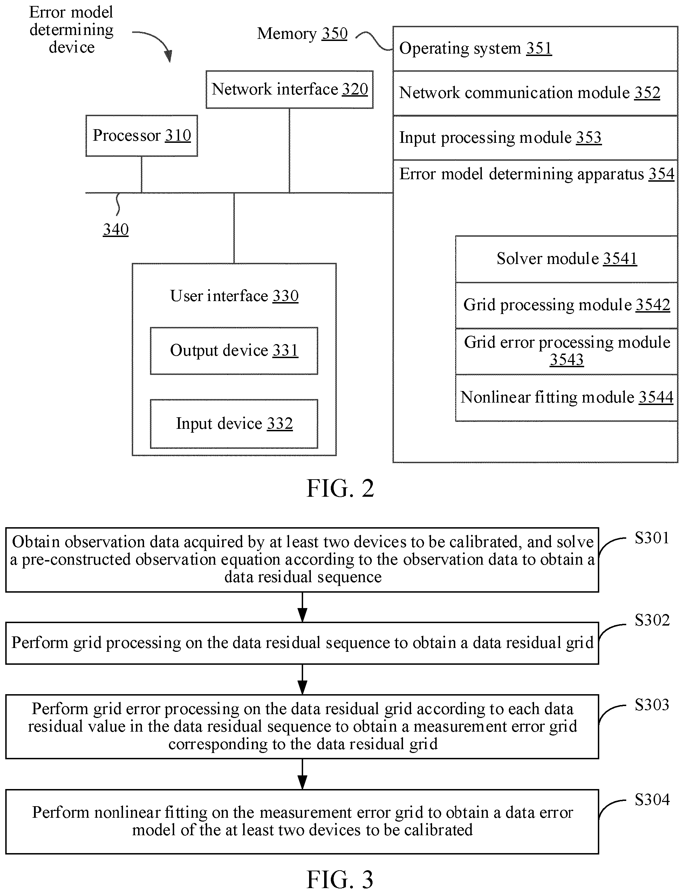

FIG. 2 is a schematic structural diagram of an error model determining device according to an embodiment of this application. The error model determining device shown in FIG. 2 includes: at least one processor 310, a memory 350, at least one network interface 320, and a user interface 330. The components in the error model determining device are coupled together by using a bus system 340. It may be understood that, the bus system 340 is configured to implement connection and communication between the components. In addition to a data bus, the bus system 340 also includes a power bus, a control bus, and a status signal bus. However, for clarity of description, all types of buses in FIG. 2 are marked as the bus system 340.

The processor 310 may be an integrated circuit chip and has a signal processing capability, for example, a general purpose processor, a digital signal processor (DSP), or another programmable logical device, a discrete gate or a transistor logical device, or a discrete hardware component. The general purpose processor may be a microprocessor, any conventional processor, or the like.

The user interface 330 includes one or more output devices 331 that enable presentation of media content, including at least one of the following: one or more speakers or one or more visual display screens. The user interface 330 further includes one or more input devices 332, including a user interface component that facilitates user input, such as a keyboard, a mouse, a microphone, a touchscreen, a camera, and other input buttons and controls.

The memory 350 may be removable, non-removable, or a combination thereof. An exemplary hardware device includes a solid state memory, a hard disk drive, an optical disk drive, or the like. The memory 350 in some embodiments includes one or more storage devices that are physically located away from the processor 310. The memory 350 includes a volatile memory or a non-volatile memory, or may include both a volatile memory and a non-volatile memory. The non-volatile memory may be a read-only memory (ROM). The volatile memory may be a random access memory (RAM). The memory 350 described in all embodiments of this application is intended to include any suitable type of memory. In some embodiments, the memory 350 can store data to support various operations. Examples of the data include programs, modules, and data structures, or subsets or supersets thereof, as exemplarily described below.

An operating system 351 includes system programs for processing various basic system services and performing hardware-related tasks, such as a framework layer, a kernel library layer, and a drive layer, and is configured to implement various basic services and process hardware-based tasks. A network communication module 352 is configured to reach another computing device through one or more (wired or wireless) network interfaces 320. An exemplary network interface 320 includes: Bluetooth, wireless fidelity (WiFi), a universal serial bus (USB), or the like. An input processing module 353 is configured to detect one or more user inputs or interactions from one of the one or more input devices 332 and translate the detected inputs or interactions.

In some embodiments, the apparatus provided in the embodiments of this application may be implemented in the form of software. FIG. 2 shows an error model determining apparatus 354 stored in the memory 350. The error model determining apparatus 354 may be an error model determining apparatus in the error model determining device, may be software in the form of a program, a plug-in, or the like, and include the following software modules: a solver module 3541, a grid processing module 3542, a grid error processing module 3543, and a nonlinear fitting module 3544. These modules are logical and therefore can be arbitrarily combined or further split depending on functions implemented. The functions of the modules are to be described below.

In some other embodiments, the apparatus provided in the embodiments of this application may be implemented in a hardware manner. In an example, the apparatus provided in the embodiments of this application may be a processor in the form of a hardware decoding processor, which is programmed to perform the error model determining method provided in the embodiments of this application. For example, the processor in the form of the hardware decoding processor may use one or more application-specific integrated circuits (ASICs), a DSP, a programmable logic device (PLD), a complex PLD (CPLD), a field-programmable gate array (FPGA), or another electronic element.

With reference to the exemplary application and implementation of the error model determining device provided in the embodiments of this application, the following describes the error model determining method provided in the embodiments of this application. The error model determining device may be any terminal with a data processing function, or may be a server. That is, the error model determining method in the embodiments of this application may be executable by a terminal or a server, or may be performed through interaction between a terminal and a server.

FIG. 3 is an optional schematic flowchart of an error model determining method according to an embodiment of this application. The following provides description with reference to steps shown in FIG. 3. The error model determining method in FIG. 3 may be implemented with a server as a main execution body.

Step S301: Obtain observation data acquired by at least two devices to be calibrated, and solve a pre-constructed observation equation according to the observation data to obtain a data residual sequence.

In this embodiment of this application, observation data acquired by at least two devices to be calibrated may be obtained. The observation data may be observation data of a target observation object, including but not limited to at least one of the following: pseudorange observation data, carrier phase observation data, and doppler observation data. The device to be calibrated may be an RTK terminal. That is, the device to be calibrated may be any device such as a terminal or a receiver that can receive a signal from the target observation object and can acquire observation data based on a satellite signal.

This embodiment of this application can implement error model calibration of a mobile terminal in a device to be calibrated, that is, determine a data error model for the mobile terminal. The error model determining method in this embodiment of this application may be applied to the following scenario: The device to be calibrated may be in an open field or fixed on a frame. After the device to be calibrated is fixed, observation of the target observation object starts, observation data of the observed target observation object is acquired, and the observation stops when observation duration reaches preset duration. When the observation stops, the device to be calibrated transmits the acquired observation data to the server (that is, the error model determining device). The preset duration includes a plurality of epochs. Therefore, the observation data actually includes observation subdata of each epoch in the plurality of epochs. Each piece of observation subdata may include a carrier-to-noise ratio, an altitude angle, pseudorange observation data, carrier phase observation data, doppler observation data, and other data that are observed. It can be understood that, the preset duration may be one day or three days, or may be other set duration.

In some embodiments, after receiving observation data sent by a device to be calibrated, the server further selects, based on the observation data, data corresponding to the observed target observation object from orbital data of the target observation object calculated based on a precise ephemeris. The selected data may include coordinates, a running speed, a clock difference, and the like of the target observation object. Subsequently, subsequent steps may be performed based on the coordinates, the running speed, the clock difference, and other data of the target observation object, as well as a location of the device to be calibrated and each piece of observation subdata, to determine the data error model, thereby implementing the error model determining method of this embodiment of this application.

In this embodiment of this application, the data residual sequence includes a pseudorange residual sequence, a carrier phase residual sequence, and doppler residual sequence. The pseudorange residual sequence includes at least a pseudorange double-difference residual sequence. The carrier phase residual sequence includes at least a carrier phase double-difference residual sequence. The doppler residual sequence includes at least a doppler single-difference residual sequence.

The observation equation may include an RTK observation equation and a doppler observation equation. The RTK observation equation is used for implementing processing of the pseudorange observation data and the carrier phase observation data to determine the pseudorange residual sequence and the carrier phase residual sequence. The doppler observation equation is used for implementing processing of the doppler observation data to determine the doppler residual sequence. In this embodiment of this application, the observation equation may be pre-constructed or the observation equation may be constructed after the observation data is obtained.

When the observation equation is an RTK observation equation, parameters in the RTK observation equation include at least: pseudorange observation data, carrier phase observation data, a location of a device to be calibrated, and a carrier phase double-difference ambiguity. The solving a pre-constructed observation equation according to the observation data may be: substituting the obtained observation data into the observation equation to obtain the location of the device to be calibrated and the carrier phase double-difference ambiguity in the equation, and then performing ambiguity fixation processing on the obtained location of the device to be calibrated and carrier phase double-difference ambiguity to obtain a fixed solution of the location of the device to be calibrated and a carrier phase double-difference ambiguity fixed value. Subsequently, the obtained fixed solution of the location of the device to be calibrated and carrier phase double-difference ambiguity fixed value are substituted into the constructed observation equation to obtain a pseudorange double-difference residual value and a carrier phase double-difference residual value. In this case, the obtained pseudorange double-difference residual value and carrier phase double-difference residual value are a pseudorange double-difference residual value and a carrier phase double-difference residual value of any moment (that is, any epoch). The foregoing manner may be continuously used to determine a pseudorange double-difference residual value and a carrier phase double-difference residual value of another moment. In this way, for pseudorange observation data and carrier phase observation data of preset duration, a pseudorange double-difference residual sequence and a carrier phase double-difference residual sequence can be correspondingly determined.

When the observation equation is a doppler observation equation, parameters in the doppler observation equation include at least: doppler observation data, a running speed of a target observation object, a clock drift of a device to be calibrated, and a clock drift of the target observation object. There is a reference observation object in a plurality of target observation objects being observed. The solving a pre-constructed observation equation according to observation data may be: substituting the doppler observation data into the observation equation to obtain a difference between doppler observation data of each target observation object and doppler observation data of the reference observation object, thereby determining the doppler single-difference residual sequence according to the difference.

In this embodiment of this application, the target observation object may be a satellite observed by the device to be calibrated, and the reference observation object may be a reference satellite.

Step S302: Perform grid processing on the data residual sequence to obtain a data residual grid.

The grid processing herein may be: mapping, based on a pre-constructed grid, each target observation object to a target grid cell in the grid, and then categorizing a data residual sequence corresponding to the target observation object into the target grid cell corresponding to the target observation object.

In this embodiment of this application, grids in different observation object systems may be pre-constructed. In other words, one grid is constructed for each of different observation object systems. For example, for different observation object systems, such as a GPS system, a GLONASS system, a GALILEO system, and a BDS system, a GPS grid of the GPS system, a GLONASS grid of the GLONASS system, a GALILEO grid of the GALILEO system, and a BDS grid of the BDS system may be constructed, respectively. Each grid includes a plurality of grid cells. Areas of all grid cells in the same grid are equal.

During the grid processing of the data residual sequence, the data residual sequence may be categorized into a target grid cell of a target observation object corresponding to the data residual sequence to obtain the data residual grid.

Step S303: Perform grid error processing on the data residual grid according to each data residual value in the data residual sequence to obtain a measurement error grid corresponding to the data residual grid.

In this embodiment of this application, grid error processing is: after a data residual sequence of each moment is calculated, calculating a standard deviation for the data residual sequence of each moment. In this case, a data measurement error standard deviation of each moment can be correspondingly obtained. Then, the obtained data measurement error standard deviation is categorized into a target grid cell of a target observation object corresponding to the data measurement error standard deviation to obtain a measurement error grid. The measurement error grid may be an observation data measurement error standard deviation grid. Alternatively, in other embodiments, grid error processing may be: directly performing standard deviation calculation for a data residual sequence in each grid cell in the data residual grid to obtain a standard deviation of the data residual sequence of the each grid cell, to further obtain a measurement error grid.

Step S304: Perform nonlinear fitting on the measurement error grid to obtain a data error model of the at least two devices to be calibrated.

In this embodiment of this application, after the measurement error grid is obtained, nonlinear fitting may be performed on the measurement error grid through a nonlinear fitting algorithm. A function relation obtained through the fitting at this time is the data error model of the at least two devices to be calibrated. Herein, performing nonlinear fitting on the measurement error grid is actually performing nonlinear fitting on an observation data measurement error standard deviation sequence in the measurement error grid. The data error model may include: a pseudorange error model, a carrier phase error model, and a doppler error model. The pseudorange error model, the carrier phase error model, and the doppler error model may be jointly used for positioning of the at least two devices to be calibrated.

In this embodiment of this application, the at least two devices to be calibrated may include a first terminal and a second terminal, and models of the first terminal and the second terminal are the same. Indicators of the first terminal and the second terminal regarding the target observation object during observation are also the same. Therefore, the server simultaneously determines data error models for the at least two devices to be calibrated.

It can be understood that, in some embodiments, the server may fit the observation data measurement error standard deviation sequence in the measurement error grid by using a least square method to obtain the data error model. In some other embodiments, the server may alternatively fit the observation data measurement error standard deviation sequence by using an artificial neural network, a convolutional neural network, and the like in an artificial intelligence technology (this is due to a powerful function fitting capability of a neural network) to obtain the data error model.

In the error model determining method provided in this embodiment of this application, a pre-constructed observation equation is solved according to observation data acquired by at least two devices to be calibrated to obtain a data residual sequence. Then, grid processing is performed on the data residual sequence, and further, a measurement error grid corresponding to the data residual grid is determined. Nonlinear fitting is performed on the measurement error grid to correspondingly obtain a data error model, thereby achieving the calibration of the data error model of the at least two devices to be calibrated. The error model determining method can accurately determine the data error model in various types of mobile terminals, thereby accurately calibrating acquired observation data based on the data error model and improving the universality of data calibration.

In some embodiments, step S303 of performing grid error processing on the data residual grid according to each data residual value in the data residual sequence to obtain a measurement error grid corresponding to the data residual grid may be implemented in the following manner: first, determining a grid cell corresponding to the each data residual value in the data residual sequence in the data residual grid; then, performing error calculation on the data residual grid according to the each data residual value in the data residual sequence to obtain an error value of each grid cell corresponding to the data residual sequence in the data residual grid; and finally, determining the measurement error grid corresponding to the data residual grid according to the error value corresponding to the each grid cell and a location of the each grid cell.

In this embodiment of this application, the data residual grid corresponds to a plurality of grid cells. Each grid cell corresponds to at least a pseudorange double-difference residual sequence, a carrier phase double-difference residual sequence, and a doppler single-difference residual sequence. In other words, the pseudorange double-difference residual sequence, the carrier phase double-difference residual sequence, and the doppler single-difference residual sequence in the data residual sequence are categorized into grid cells of the pre-constructed grid.

Herein, standard deviation calculation may be performed on the data residual grid according to the each data residual value in the data residual sequence to obtain the error standard deviation value of the each grid cell corresponding to the data residual sequence in the data residual grid, and the error standard deviation value is determined as an error value. The data residual value includes, but is not limited to: a pseudorange double-difference residual value, a carrier phase double-difference residual value, and a doppler single-difference residual value.

In some embodiments, the error standard deviation value corresponding to the each grid cell may be categorized into the corresponding grid cell according to the location of the each grid cell to obtain categorized grid cells; and the categorized grid cells are aggregated to obtain the measurement error grid.

In this embodiment of this application, the location of each grid cell refers to a corresponding location of the grid cell in the grid. The location may be a coordinate location of the grid cell, or a location identifier may be added in advance to each grid cell in the constructed grid and a location of the grid cell in the grid may be determined according to the location identifier.

In this embodiment of this application, the measurement error grid corresponding to the data residual grid is determined based on the pre-constructed grid. Each data residual in the data residual sequence is categorized into each grid cell in the grid. Subsequently, the calculated error standard deviation value may also be categorized into the grid cell based on the location of the data residual in the grid cell in the grid, thereby achieving accurate matching between the calculated error standard deviation value and the data residual sequence. In addition, because the pre-constructed grid includes a plurality of grid cells with equal areas, during subsequent nonlinear fitting of the measurement error grid obtained based on the grid, data can be accurately fitted to obtain an accurate data error model.

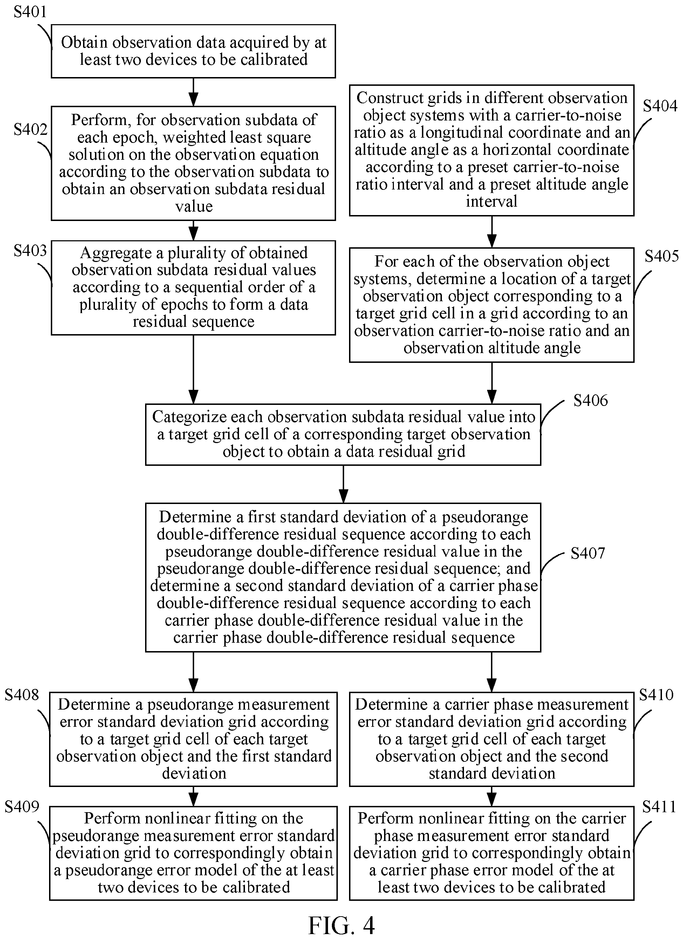

FIG. 4 is another optional schematic flowchart of an error model determining method according to an embodiment of this application. As shown in FIG. 4, the method includes the following steps:

Step S401: Obtain observation data acquired by at least two devices to be calibrated.

In some embodiments, the observation data includes observation subdata of each epoch in a plurality of epochs.

Step S402: Perform, for the observation subdata of the each epoch, weighted least square solution on the observation equation according to the observation subdata to obtain an observation subdata residual value.

In this embodiment of this application, the observation subdata comprises a pseudorange and a carrier phase, the observation subdata residual value may be an observation subdata double-difference residual value, and the observation equation is an RTK observation equation.

In some embodiments, step S402 may be implemented in the following manner: first, performing, for the each epoch, weighted least square solution on the RTK observation equation according to the observation subdata of the epoch to obtain location information and a carrier phase ambiguity floating point solution of any of the devices to be calibrated; then, performing ambiguity fixation on the carrier phase ambiguity floating point solution to obtain a carrier phase ambiguity fixed value; then, solving the carrier phase ambiguity fixed value to obtain a fixed solution of the location information, and substituting the fixed solution of the location information and the carrier phase ambiguity fixed value into the RTK observation equation to obtain a pseudorange residual value and a carrier phase residual value; and finally, determining the pseudorange residual value and the carrier phase residual value as observation subdata residual values corresponding to the observation subdata.

Herein, weighted least square solution may be performed on the RTK observation equation based on observation subdata of a reference station and observation subdata of the epoch acquired by a target calibration device to obtain location information of the target calibration device and a carrier phase double-difference ambiguity floating point solution.

Parameters in the RTK observation equation include at least: a geometric distance between the target calibration device and each target observation object, pseudorange observation data, carrier phase observation data, a location of a device to be calibrated, and a carrier phase double-difference ambiguity.

In an actual process, in each epoch, a target observation object observed by the target calibration device is different from a target observation object observed by the reference station. Therefore, an observation data residual sequence needs to be calibrated with reference to parameters corresponding to each common target observation object jointly observed by the target calibration device and the reference station, and needs to be calibrated with reference to parameters corresponding to a reference observation object corresponding to the each jointly observed target observation object. The parameters corresponding to the each common target observation object and the parameters of the reference observation object of the each common target observation object are denoted as matching parameters. In other words, the matching parameters include the parameters of the target observation object jointly observed by the target calibration device and the reference station and the parameters of the reference observation object of the jointly observed target observation object.

During calibration of an observation data residual sequence, an error model calibration device needs to analyze observation subdata of all epochs and matching parameters of all the epochs, so that a distribution status of the target calibration device and the reference station at different carrier-to-noise ratios and altitude angles can be determined, thereby obtaining the data residual sequence corresponding to both the target calibration device and the reference station.

It can be understood that, because data of a target observation object data is obtained based on observation data and from orbital data of each target observation object calculated based on a precise ephemeris, the matching parameters are also part of the orbital data of the each target observation object calculated based on the precise ephemeris.

In this embodiment of this application, weighted least square solution may be performed on the RTK observation equation with reference to the observation subdata of each epoch and matching parameters of all the target observation objects to obtain location information of any device to be calibrated and a carrier phase double-difference ambiguity floating point solution in the epoch. The location information of the device to be calibrated and the carrier phase double-difference ambiguity floating point solution may be substituted back into the RTK observation equation as parameters in the RTK observation equation to obtain the observation data residual sequence.

In this embodiment of this application, when the observation subdata includes a pseudorange and a carrier phase, the carrier phase ambiguity floating point solution may be a carrier phase double-difference ambiguity floating point solution, and the carrier phase ambiguity fixed value may be a carrier phase double-difference ambiguity fixed value.

In this embodiment of this application, the observation subdata residual value of the observation subdata includes a pseudorange residual value and a carrier phase residual value. In some embodiments, the pseudorange residual value and the carrier phase residual value may be respectively a pseudorange double-difference residual value and a carrier phase double-difference residual value.

Step S403: Aggregate a plurality of obtained observation subdata residual values according to a sequential order of a plurality of epochs to form a data residual sequence.

In this embodiment of this application, observation subdata of each epoch is processed sequentially according to the foregoing step S4021 to step S4025 to obtain a pseudorange double-difference residual value and a carrier phase double-difference residual value in the epoch. Then, pseudorange double-difference residual values and carrier phase double-difference residual values in a plurality of epochs are aggregated to form a pseudorange double-difference residual value sequence and a carrier phase double-difference residual value sequence. The observation data residual sequence includes the pseudorange double-difference residual value sequence and the carrier phase double-difference residual value sequence.

Step S404: Construct grids in different observation object systems with a carrier-to-noise ratio as a longitudinal coordinate and an altitude angle as a horizontal coordinate according to a preset carrier-to-noise ratio interval and a preset altitude angle interval.

It can be understood that all target observation objects jointly observed by two devices to be calibrated include target observation objects in one or more preset observation object systems. The preset observation object system may include a GPS system, a GLONASS system, a GALILEO system, a BDS system, or other systems. In this embodiment of this application, a carrier-to-noise ratio and an altitude angle of a jointly observed target observation object may be obtained, and a plurality of carrier-to-noise ratio-altitude angle category units are constructed for each preset observation object system in one or more preset observation object systems to which the jointly observed target observation object belongs. Such a carrier-to-noise ratio-altitude angle category unit is denoted as a system carrier-to-noise ratio-altitude angle category unit. In this way, an error model determining device obtains carrier-to-noise ratio-altitude angle category units in a plurality of systems. It can be understood that a plurality of system carrier-to-noise ratio-altitude angle category units in each preset observation object system may constitute a grid corresponding to the preset observation object system. In other words, grids in different observation object systems may be constructed with a carrier-to-noise ratio as a longitudinal coordinate and an altitude angle as a horizontal coordinate according to a preset carrier-to-noise ratio interval and a preset altitude angle interval. In the same grid, the preset carrier-to-noise ratio interval and the preset altitude angle interval are side lengths of each grid cell in the grid.

Step S405: For each of the observation object systems, determine a location of a target observation object corresponding to a target grid cell in a grid according to an observation carrier-to-noise ratio and an observation altitude angle.

Herein, the target observation object at the location corresponding to the target grid cell in the grid refers to a target observation object observed by the device to be calibrated, that is, a target observation object corresponds to the observation data. An observation carrier-to-noise ratio and an observation altitude angle of the target observation object may be obtained, and then a corresponding grid cell is determined in the grid according to the observation carrier-to-noise ratio and the observation altitude angle, as the target grid cell.

Step S406: Categorize each observation subdata residual value into a target grid cell of a corresponding target observation object to obtain a data residual grid.

In this embodiment of this application, a pseudorange double-difference residual value and a carrier phase double-difference residual value in each observation subdata residual value may be categorized into the target grid cell of the corresponding target observation object. A target grid cell of each target observation object corresponds to a pseudorange double-difference residual sequence and a carrier phase double-difference residual sequence.

Step S407: Determine a first standard deviation of a pseudorange double-difference residual sequence according to each pseudorange double-difference residual value in the pseudorange double-difference residual sequence; and determine a second standard deviation of a carrier phase double-difference residual sequence according to each carrier phase double-difference residual value in the carrier phase double-difference residual sequence.

Herein, a first standard deviation of a pseudorange double-difference residual sequence of each moment and a second standard deviation of a carrier phase double-difference residual sequence of each moment may be calculated.

Step S408: Determine a pseudorange measurement error standard deviation grid according to a target grid cell of each target observation object and the first standard deviation.

In this embodiment of this application, after the first standard deviation of the pseudorange double-difference residual sequence of each moment is calculated, the obtained first standard deviation is categorized into a target grid cell of a target observation object corresponding to the first standard deviation to obtain a pseudorange measurement error standard deviation grid. The pseudorange measurement error standard deviation grid can describe the discrete distribution of pseudorange measurement error standard deviations of the at least two devices to be calibrated at the carrier-to-noise ratio and the altitude angle of the target observation object.

Step S409: Perform nonlinear fitting on the pseudorange measurement error standard deviation grid to correspondingly obtain a pseudorange error model of the at least two devices to be calibrated.

In this embodiment of this application, nonlinear fitting may be performed on the pseudorange measurement error standard deviation grid to obtain a first function relation of a pseudorange measurement error standard deviation with respect to a carrier-to-noise ratio and an altitude angle, and the pseudorange error model of the at least two devices to be calibrated is obtained according to the first function relation.

Step S410: Determine a carrier phase measurement error standard deviation grid according to a target grid cell of each target observation object and the second standard deviation.

In this embodiment of this application, after a second standard deviation of a pseudorange double-difference residual sequence of each moment is calculated, the obtained second standard deviation is categorized into a target grid cell of a target observation object corresponding to the second standard deviation to obtain a carrier phase measurement error standard deviation grid. The carrier phase measurement error standard deviation grid can describe the discrete distribution of carrier phase measurement error standard deviations of the at least two devices to be calibrated at the carrier-to-noise ratio and the altitude angle of the target observation object.

Step S411: Perform nonlinear fitting on the carrier phase measurement error standard deviation grid to correspondingly obtain a carrier phase error model of the at least two devices to be calibrated.

In this embodiment of this application, nonlinear fitting may be performed on the carrier phase measurement error standard deviation grid to obtain a second function relation of a carrier phase measurement error standard deviation with respect to the carrier-to-noise ratio and the altitude angle, and the carrier phase error model of the at least two devices to be calibrated is obtained according to the second function relation.

In this embodiment of this application, the first standard deviation of the pseudorange double-difference residual sequence and the second standard deviation of the carrier phase double-difference residual sequence are separately calculated, and then, the pseudorange measurement error standard deviation grid is determined based on the first standard deviation and the carrier phase measurement error standard deviation grid is determined based on the second standard deviation, so that nonlinear fitting can be performed on the pseudorange measurement error standard deviation grid and the carrier phase measurement error standard deviation grid to obtain a pseudorange error model and a carrier phase error model, respectively. The pseudorange error model can achieve calibration of a pseudorange in the observed observation data, and the carrier phase error model can achieve calibration of a carrier phase in the observed observation data. In this way, targeted error calibration is performed on the corresponding observation data based on the two types of error models, respectively, so that the observation data can be more accurately calibrated.

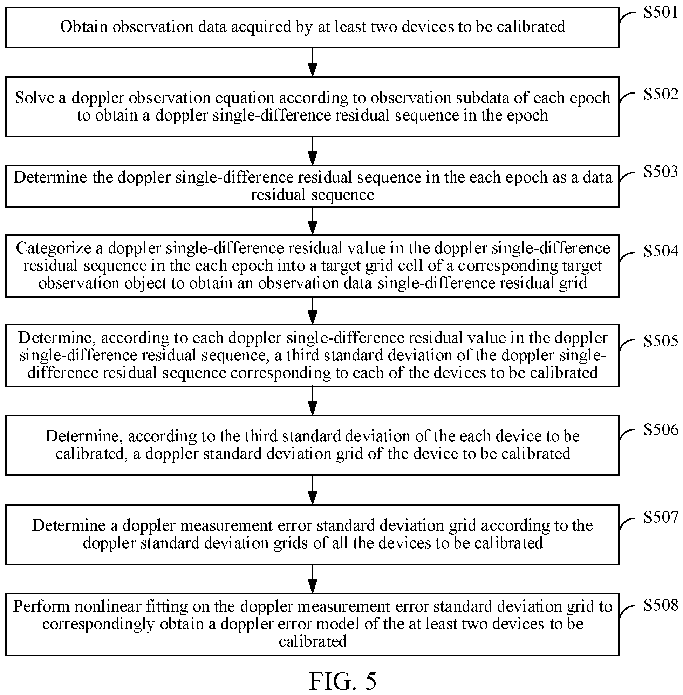

FIG. 5 is still another optional schematic flowchart of an error model determining method according to an embodiment of this application. As shown in FIG. 5, the method includes the following steps:
Step S501: Obtain observation data acquired by at least two devices to be calibrated.

In some embodiments, the observation data includes observation subdata of each epoch in a plurality of epochs. The observation equation is a doppler observation equation.

Step S502: Solve a doppler observation equation according to the observation subdata of the each epoch to obtain a doppler single-difference residual sequence in the epoch.

Step S503: Determine the doppler single-difference residual sequence in the each epoch as a data residual sequence.

Step S504: Categorize a doppler single-difference residual value in the doppler single-difference residual sequence in the each epoch into a target grid cell of a corresponding target observation object to obtain an observation data single-difference residual grid, a target grid cell of each target observation object being corresponding to a doppler single-difference residual sequence.

Step S505: Determine, according to each doppler single-difference residual value in the doppler single-difference residual sequence, a third standard deviation of the doppler single-difference residual sequence corresponding to each of the devices to be calibrated

Step S506: Determine, according to the third standard deviation of the each device to be calibrated, a doppler standard deviation grid of the device to be calibrated.

Step S507: Determine a doppler measurement error standard deviation grid according to the doppler standard deviation grids of all the devices to be calibrated.

Step S508: Perform nonlinear fitting on the doppler measurement error standard deviation grid to correspondingly obtain a doppler error model of the at least two devices to be calibrated.

In this embodiment of this application, nonlinear fitting may be performed on the doppler measurement error standard deviation grid to obtain a third function relation of a doppler measurement error standard deviation with respect to a carrier-to-noise ratio and an altitude angle, and the doppler error model of the at least two devices to be calibrated is obtained according to the third function relation.

In this embodiment of this application, the third standard deviation of the doppler single-difference residual sequence is calculated, and then, the doppler measurement error standard deviation grid is determined based on the third standard deviation, so that nonlinear fitting can be performed on the doppler measurement error standard deviation grid to obtain a doppler error model. The doppler error model can achieve calibration of doppler data in observed observation data. In this way, targeted error calibration is performed on the doppler data in the corresponding observation data based on the doppler error model, so that the doppler data in the observation data can be more accurately calibrated.

The following describes an exemplary application of the embodiments of this application in an actual application scenario.

An embodiment of this application provides an error model determining method. This method is a method for calibrating an observation random error model by using a signal power splitter. The signal power splitter splits a satellite signal into two paths to two identical RTK terminals (that is, the foregoing devices to be calibrated), acquires pseudorange, carrier phase, and doppler observation data of each of identical positioning modules a and b in the two RTK terminals, constructs a zero baseline based on the observation data, and performs RTK solution on the observation data. Then, grid processing is performed on a pseudorange double-difference residual sequence, a carrier phase double-difference residual sequence, and a doppler single-difference residual sequence. In addition, nonlinear fitting is performed on a function relation of a pseudorange measurement error standard deviation with respect to a carrier-to-noise ratio CNO and an altitude angle, a function relation of a carrier phase measurement error standard deviation with respect to the carrier-to-noise ratio CNO and the altitude angle, and a function relation of a doppler measurement error standard deviation with respect to the carrier-to-noise ratio CNO and the altitude angle.

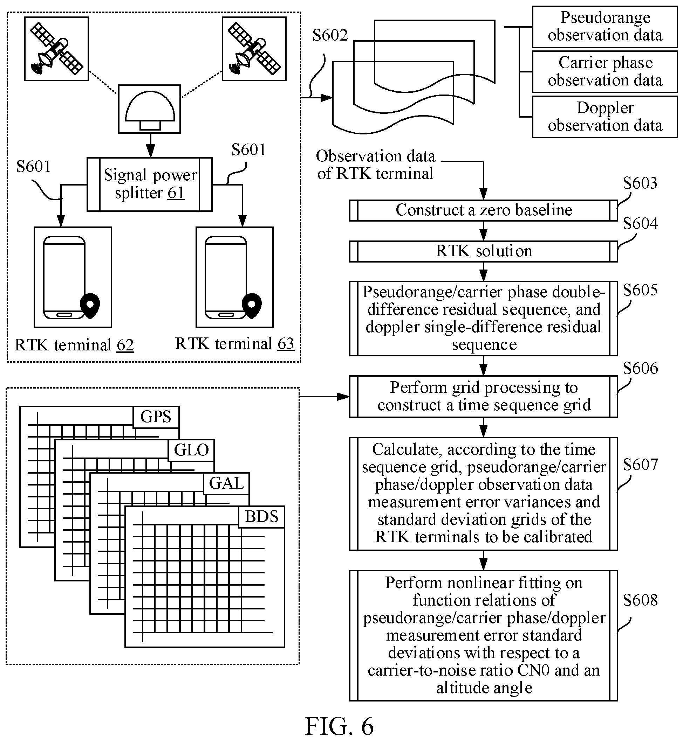

FIG. 6 is a schematic flowchart of an error model determining method according to an embodiment of this application. As shown in FIG. 6, the method includes the following steps:

Step S601: A signal power splitter 61 sends a satellite signal to two identical RTK terminals 62 and 63 through two paths.

Step S602: Acquire, from positioning modules in the two identical RTK terminals, observation data: pseudorange observation data, carrier phase observation data, and doppler observation data.

Step S603: Construct a zero baseline.

Step S604: Perform RTK solution.

Step S605: Obtain a pseudorange double-difference residual sequence, a carrier phase double-difference residual sequence, and a doppler single-difference residual sequence.

Step S606: Perform grid processing on different observation object systems to construct a time sequence grid.

Step S607: Calculate, according to the time sequence grid, pseudorange observation data measurement error variances and standard deviations, carrier phase observation data measurement error variances and standard deviations, and doppler observation data measurement error variances and standard deviation grids of the RTK terminals 62 and 63 to be calibrated.

Step S608: Perform nonlinear fitting on function relations of a pseudorange measurement error standard deviation, a carrier phase measurement error standard deviation, and a doppler measurement error standard deviation with respect to a carrier-to-noise ratio CNO and an altitude angle to obtain an observation random error model, that is, a data error model.

The following describes a procedure for determining a pseudorange observation random error model, a procedure for determining a carrier phase observation random error model, and a procedure for determining a doppler observation random error model.

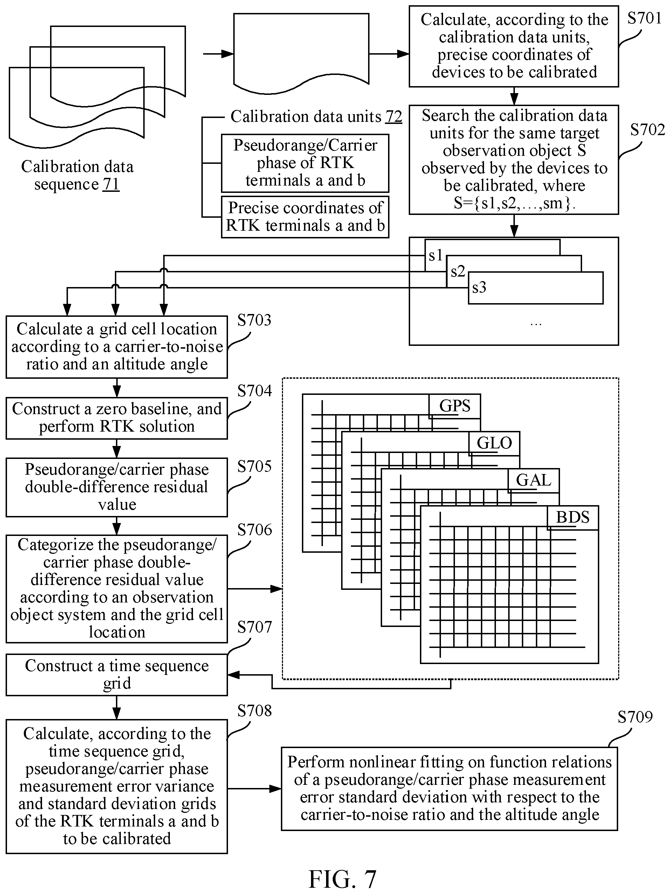

FIG. 7 is a schematic flowchart of a determining procedure of a pseudorange and a carrier phase observation random error model according to an embodiment of this application. As shown in FIG. 7, a calibration data sequence 71 is observed observation data. The calibration data sequence 71 includes calibration data units 72 (that is, observation subdata) observed in a plurality of epochs. The calibration data unit 72 includes pseudorange observation data or carrier phase observation data of an RTK terminal a and an RTK terminal b and precise coordinates of the RTK terminal a and the RTK terminal b. After the calibration data units 72 are obtained, a calibration procedure includes the following steps:

Step S701: Calculate, according to the calibration data units, precise coordinates of devices to be calibrated (that is, the RTK terminal a and the RTK terminal b).
Step S702: Search the calibration data units for the same target observation object S observed by the devices to be calibrated, where S={s1, s2 ⋯ sm}.
Step S703: Calculate a grid cell location according to a carrier-to-noise ratio and an altitude angle.
Step S704: Construct a zero baseline, and perform RTK solution.
Step S705: Calculate a pseudorange phase double-difference residual value or a carrier phase double-difference residual value.

In this embodiment of this application, after pseudorange or carrier phase zero baseline observation data of the RTK terminal a and the RTK terminal b is obtained, RTK solution is performed on the zero baseline observation data. It is assumed that at moment t, the RTK terminal a and the RTK terminal b view m target observation objects in total. In this case, RTK observation equations $z_\rho$ and $z_\varphi$ of the following formulas (1) and (2) are constructed:

$$
z_\rho = \begin{bmatrix} \rho_{ab}^{12} \\ \rho_{ab}^{13} \\ \vdots \\ \rho_{ab}^{1m} \end{bmatrix} - \begin{bmatrix} r_a^1 - r_a^2 - \left( r_b^1 - r_b^2 \right) + \mathrm{I}_{ab}^{12} + \mathrm{T}_{ab}^{12} \\ r_a^1 - r_a^3 - \left( r_b^1 - r_b^3 \right) + \mathrm{I}_{ab}^{13} + \mathrm{T}_{ab}^{13} \\ \vdots \\ r_a^1 - r_a^m - \left( r_b^1 - r_b^m \right) + \mathrm{I}_{ab}^{1m} + \mathrm{T}_{ab}^{1m} \end{bmatrix} \qquad (1);
$$

and

$$
z_\varphi = \begin{bmatrix} \varphi_{ab}^{12} \\ \varphi_{ab}^{13} \\ \vdots \\ \varphi_{ab}^{1m} \end{bmatrix} - \begin{bmatrix} r_a^1 - r_a^2 - \left( r_b^1 - r_b^2 \right) + \mathrm{I}_{ab}^{12} + \mathrm{T}_{ab}^{12} + \lambda B_{ab}^{12} \\ r_a^1 - r_a^3 - \left( r_b^1 - r_b^3 \right) + \mathrm{I}_{ab}^{13} + \mathrm{T}_{ab}^{13} + \lambda B_{ab}^{13} \\ \vdots \\ r_a^1 - r_a^m - \left( r_b^1 - r_b^m \right) + \mathrm{I}_{ab}^{1m} + \mathrm{T}_{ab}^{1m} + \lambda B_{ab}^{1m} \end{bmatrix} \qquad (2).
$$

$r_a^i$ represents a geometric distance between the RTK terminal a and a target observation object $i$, and $i = 1,2,...,m$. $r_b^i$ represents a geometric distance between the RTK terminal b and the target observation object $i$, and $i = 1, 2, ..., m$.

$\rho_{ab}^{12} = \rho_a^1 - \rho_a^2 - \left( \rho_b^1 - \rho_b^2 \right)$, $\varphi_{ab}^{12} = \varphi_a^1 - \varphi_a^2 - \left( \varphi_b^1 - \varphi_b^2 \right)$, and the rest can be deduced by analogy, where $\rho_a^i$ represents a pseudorange observation value from the RTK terminal a to the target observation object 1, and $i = 1,2,...,m$; $\rho_b^i$ represents a pseudorange observation value from the RTK terminal b to the target observation object $i$, and $i = 1,2,...,m$; $\rho_{ab}^{12}$ represents a pseudorange double-difference observation value formed by the RTK terminals a and b, a target observation object 1, and a target observation object 2; and the rest can be deduced by analogy. $\varphi_a^i$ represents a carrier phase observation value from the RTK terminal a to the target observation object $i$, and $i = 1,2,...,m$; $\varphi_b^i$ represents a carrier phase observation value from the RTK terminal b to the target observation object $i$, and $i = 1,2,...,m$; $\varphi_{ab}^{12}$ represents a carrier phase double-difference observation value formed by the RTK terminals a and b, the target observation object 1, and the target observation object 2; and the rest can be deduced by analogy. $\mathrm{I}_{ab}^{12}$, $\mathrm{I}_{ab}^{13}$, $\cdots$, and $\mathrm{I}_{ab}^{1m}$ are each a double-difference ionospheric delay, and may be calculated by using an empirical model. $\mathrm{T}_{ab}^{12}$, $\mathrm{T}_{ab}^{13}$, ..., and $\mathrm{T}_{ab}^{1m}$ are each a double-difference tropospheric delay, and may be calculated by using an empirical model. The target observation object 1 may be a reference observation object.

With the RTK terminal b as a reference station, weighted least square solution or Kalman filter solution is performed on the foregoing formulas (1) and (2) to obtain a location $r_a$ of the RTK terminal a and floating point solutions of carrier phase double-difference ambiguities $B_{ab}^{12}$, $B_{ab}^{13}$, $\cdots$, and $B_{ab}^{1m}$. The carrier phase double-difference ambiguities $B_{ab}^{12}$, $B_{ab}^{13}$, $\cdots$, and $B_{ab}^{1m}$ are each an integer. Ambiguity fixation is performed by using an MLAMBDA method to obtain carrier phase double-difference ambiguity fixed values $\tilde{B}_{ab}^{12}$, $\tilde{B}_{ab}^{13}$, $\cdots$, and $\tilde{B}_{ab}^{1m}$. A fixed solution $\tilde{r}_a$ of a location $r_a$ of the RTK terminal a is obtained through solving from a carrier phase ambiguity fixed value. $\tilde{r}_a$, $\tilde{B}_{ab}^{12}$, $\tilde{B}_{ab}^{13}$, $\cdots$

, and $\tilde{B}_{ab}^{1m}$ are substituted into the RTK observation equation as known values, and pseudorange and carrier phase double-difference residual values can be obtained, referring to the following formulas (3) and (4):

$$
\begin{bmatrix} \tilde{z}_{\rho 2} \\ \tilde{z}_{\rho 3} \\ \vdots \\ \tilde{z}_{\rho m} \end{bmatrix} = \begin{bmatrix} \rho_{ab}^{12} \\ \rho_{ab}^{13} \\ \vdots \\ \rho_{ab}^{1m} \end{bmatrix} - \begin{bmatrix} \tilde{r}_a^1 - \tilde{r}_a^2 - \left( r_b^1 - r_b^2 \right) + \mathrm{I}_{ab}^{12} + \mathrm{T}_{ab}^{12} \\ \tilde{r}_a^1 - \tilde{r}_a^3 - \left( r_b^1 - r_b^3 \right) + \mathrm{I}_{ab}^{13} + \mathrm{T}_{ab}^{13} \\ \vdots \\ \tilde{r}_a^1 - \tilde{r}_a^m - \left( r_b^1 - r_b^m \right) + \mathrm{I}_{ab}^{1m} + \mathrm{T}_{ab}^{1m} \end{bmatrix} \quad (3);
$$

and

$$
\begin{bmatrix} \tilde{z}_{\varphi 2} \\ \tilde{z}_{\varphi 3} \\ \vdots \\ \tilde{z}_{\varphi m} \end{bmatrix} = \begin{bmatrix} \varphi_{ab}^{12} \\ \varphi_{ab}^{13} \\ \vdots \\ \varphi_{ab}^{1m} \end{bmatrix} - \begin{bmatrix} \tilde{r}_a^1 - \tilde{r}_a^2 - \left( r_b^1 - r_b^2 \right) + \mathrm{I}_{ab}^{12} + \mathrm{T}_{ab}^{12} + \lambda \tilde{B}_{ab}^{12} \\ \tilde{r}_a^1 - \tilde{r}_a^3 - \left( r_b^1 - r_b^3 \right) + \mathrm{I}_{ab}^{13} + \mathrm{T}_{ab}^{13} + \lambda \tilde{B}_{ab}^{13} \\ \vdots \\ \tilde{r}_a^1 - \tilde{r}_a^m - \left( r_b^1 - r_b^m \right) + \mathrm{I}_{ab}^{1m} + \mathrm{T}_{ab}^{1m} + \lambda \tilde{B}_{ab}^{1m} \end{bmatrix} \quad (4).
$$

Pseudorange and carrier phase double-difference residual sequences of N moments can be obtained by performing the foregoing processing on pseudorange or carrier phase data of the RTK terminal a and the RTK terminal b of the N moments.

Step S706: Categorize the pseudorange phase double-difference residual value or the carrier phase double-difference residual value according to an observation object system and the grid cell location.

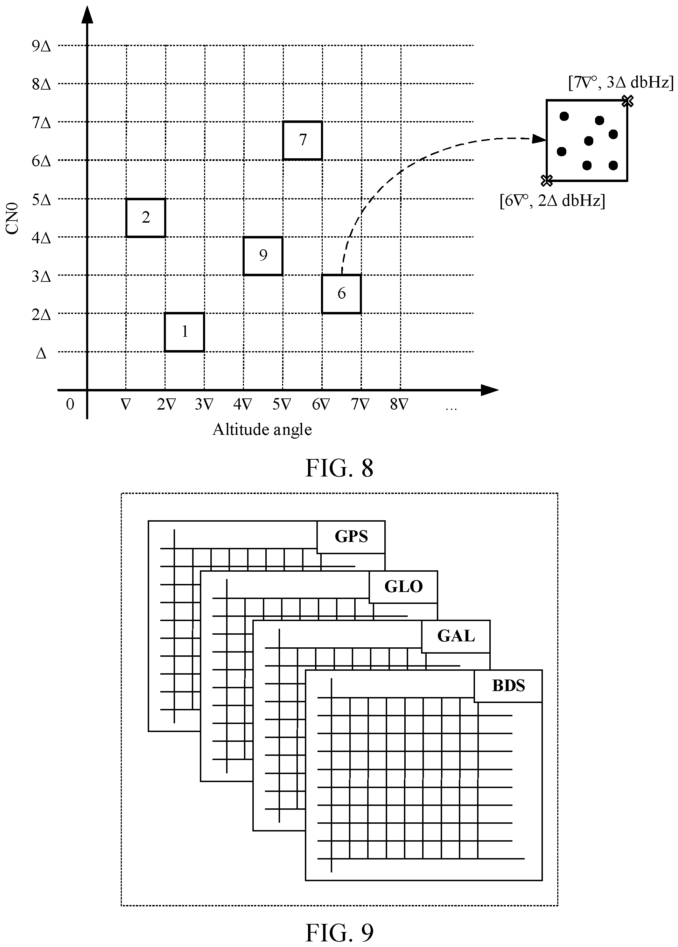

Carrier-to-noise ratios CNO and altitude angles are arranged at particular intervals to form a grid. Herein, the particular intervals may be a length and a width of each grid cell in the grid. FIG. 8 is a schematic diagram of a grid of carrier-to-noise ratios CNO and altitude angles according to an embodiment of this application. Observation object systems usually include GPS, GLONASS, GALILEO, and BDS systems. Therefore, four grids respectively corresponding to the four observation object systems may be constructed. FIG. 9 is a schematic diagram of grids of GPS, GLONASS, GALILEO, and BDS systems according to an embodiment of this application. Assuming that carrier-to-noise ratio and altitude angle intervals of the grids of GPS and GLONASS (represented by GLO in FIG. 9), GALILEO (represented by GAL in FIG. 9), and BDS are $\Delta$ and $\nabla$, a grid cell may be expressed as the following formula (5):

$$
\left\{ \left[ a_i, b_i \right], \left[ c_j, d_j \right] \right\} \quad (5).
$$

Still referring to FIG. 8, a carrier-to-noise ratio interval and an altitude angle interval are $\Delta$ dBHz and $\nabla°$, respectively, and reference numerals 1, 2, 6, 7, and 9 in the figure represent target observation object numbers: For example, when $\Delta=\nabla=5$, if a target observation object 2 has a pseudorange observation value signal-to-noise ratio of 21 dBHz and an altitude angle of 8°, a pseudorange double-difference residual value of the target observation object 2 is placed at the reference numeral 2 in FIG. 8. By analogy, pseudorange double-difference residual values of all epochs are categorized into the grid for placement.

In the foregoing formula (5), $[a_i, b_i]$ are upper and lower boundary values of the grid cell, $[c_j, d_j]$ are left and right boundary values of the grid cell, and there is the following formula (6):

$$
\begin{cases} a_i = i \cdot \Delta \\ c_j = j \cdot \nabla \end{cases}, \begin{cases} b_i - a_i = \Delta \\ d_j - c_j = \nabla \end{cases} \quad (6),
$$

where $i = 0,1,...$; $j = 0,1,...$; and $\Delta$ and $\nabla$ respectively represent left-right and upper-lower intervals (that is, the carrier-to-noise ratio interval and the altitude angle interval) of the grid cells.

Step S707: Construct a time sequence grid.

Step S708: Calculate, according to the time sequence grid, pseudorange/carrier phase measurement error variance and standard deviation grids of the devices to be calibrated.

In this embodiment of this application, grid processing may be performed on the pseudorange double-difference

residual sequence $\begin{bmatrix} \tilde{z}_{\rho 2} \\ \tilde{z}_{\rho 3} \\ \vdots \\ \tilde{z}_{\rho m} \end{bmatrix}$ by using the following steps:

First, assuming that a carrier-to-noise ratio and an altitude angle of a target observation object $i, i = 2, 3, \ldots, m$

are $CN0_i$ and $el_i$, and a grid cell location of the target observation object $i$ is calculated, that is, $p = \left[ \dfrac{CN0_i}{\Delta} \right], q = \left[ \dfrac{el_i}{\nabla} \right]$

, where $[\cdot]$ represents a rounding operation. Then, a pseudorange double-difference residual $\tilde{z}_{\rho i}$ is categorized into a grid cell of a corresponding observation object system: If the target observation object $i$ belongs to a GPS system, the pseudorange double-difference residual is categorized into a GPS grid cell $\{[a_p, b_p], [c_q, d_q]\}$, If the target observation object $i$ belongs to a GLONASS system, the pseudorange double-difference residual is categorized into a GLONASS grid cell $\{[a_p, b_p], [c_q, d_q]\}$, If the target observation object $i$ belongs to a GALILEO system, the pseudorange double-difference residual is categorized into a GALILEO grid cell $\{[a_p, b_p], [c_q, d_q]\}$, If the target observation object $i$ belongs to a BDS system, the pseudorange double-difference residual is categorized into a BDS grid cell $\{[a_p, b_p], [c_q, d_q]\}$. Finally, by analogy, the foregoing processing is performed on each element in the pseudorange double-difference residual

sequence $\begin{bmatrix} \tilde{z}_{\rho 2} \\ \tilde{z}_{\rho 3} \\ \vdots \\ \tilde{z}_{\rho m} \end{bmatrix}$ .

Similarly, the foregoing processing is also performed on the carrier phase double-difference residual sequence

$\begin{bmatrix} \tilde{z}_{\varphi 2} \\ \tilde{z}_{\varphi 3} \\ \vdots \\ \tilde{z}_{\varphi m} \end{bmatrix}$ . The foregoing processing is performed on pseudorange double-difference residual sequences of all moments.

In this case, each grid cell corresponds to one pseudorange double-difference residual value sequence, which is expressed as the following formula (7):

$$s_{\mathrm{SYS}}\left(\left[a_i, b_i\right], \left[c_j, d_j\right]\right) = \left\{z_1, z_2, \cdots, z_l\right\}, i = 0, 1, \ldots; j = 0, 1, \ldots; \mathrm{SYS} = \mathrm{GPS}, \mathrm{GLO}, \mathrm{GAL}, \mathrm{BDS} \quad (7).$$

Sequence grids of the following formulas (8) to (11) are constructed:

$$\Upsilon_{m \times n, \mathrm{GPS}} = \begin{bmatrix} s_{\mathrm{GPS}}\left(\left[a_m, b_m\right], \left[c_0, d_0\right]\right) & \cdots & s_{\mathrm{GPS}}\left(\left[a_m, b_m\right], \left[c_n, d_n\right]\right) \\ \vdots & \ddots & \vdots \\ s_{\mathrm{GPS}}\left(\left[a_0, b_0\right], \left[c_0, d_0\right]\right) & \cdots & s_{\mathrm{GPS}}\left(\left[a_0, b_0\right], \left[c_n, d_n\right]\right) \end{bmatrix} \quad (8);$$

$$\Upsilon_{m \times n, \text{GLO}} = \begin{bmatrix} s_{\text{GLO}}([a_m, b_m],[c_0, d_0]) & \cdots & s_{\text{GLO}}([a_m, b_m],[c_n, d_n]) \\ \vdots & \ddots & \vdots \\ s_{\text{GLO}}([a_0, b_0],[c_0, d_0]) & \cdots & s_{\text{GLO}}([a_0, b_0],[c_n, d_n]) \end{bmatrix} \qquad (9);$$

$$\Upsilon_{m \times n, \text{GAL}} = \begin{bmatrix} s_{\text{GAL}}([a_m, b_m],[c_0, d_0]) & \cdots & s_{\text{GAL}}([a_m, b_m],[c_n, d_n]) \\ \vdots & \ddots & \vdots \\ s_{\text{GAL}}([a_0, b_0],[c_0, d_0]) & \cdots & s_{\text{GAL}}([a_0, b_0],[c_n, d_n]) \end{bmatrix} \qquad (10);$$

and

$$\Upsilon_{m \times n, \text{BDS}} = \begin{bmatrix} s_{BDS}([a_m, b_m],[c_0, d_0]) & \cdots & s_{\text{BDS}}([a_m, b_m],[c_n, d_n]) \\ \vdots & \ddots & \vdots \\ s_{\text{BDS}}([a_0, b_0],[c_0, d_0]) & \cdots & s_{\text{BDS}}([a_0, b_0],[c_n, d_n]) \end{bmatrix} \qquad (11).$$

Assuming that the maximum carrier-to-noise ratio and altitude angle are $CN0_{max}$ and $el_{max}$, there is a relation as the following formula (12):

$$b_m = \left( \left[ \frac{CN0_{max}}{\Delta} \right] + 1 \right) \cdot \Delta, d_n = \left( \left[ \frac{el_{max}}{\nabla} \right] + 1 \right) \cdot \nabla \qquad (12).$$

A standard deviation of the pseudorange double-difference residual value sequence $s_{SYS}([a_i, b_i],[c_j, d_j])$ corresponding to the grid cell is calculated to obtain the following formula (13):

$$\sigma_{SYS}(b_i, d_j) \approx \sqrt{\frac{1}{l} \cdot \sum_{k=1}^{l} \left( z_k - \frac{1}{l} \cdot \sum_{m=1}^{l} z_m \right)^2}, i = 0, 1, \ldots; j = 0, 1, \ldots; SYS = GPS, GLO, GAL, BDS \qquad (13).$$

In this way, pseudorange measurement error standard deviation grids, that is, the following formulas (14) to (17), can be obtained:

$$\tilde{\Psi}_{m \times n, \text{GPS}} = \begin{bmatrix} \tilde{\sigma}_{\text{GPS}}(b_m, d_0) & \cdots & \tilde{\sigma}_{\text{GPS}}(b_m, d_n) \\ \vdots & \ddots & \vdots \\ \tilde{\sigma}_{\text{GPS}}(b_0, d_0) & \cdots & \tilde{\sigma}_{\text{GPS}}(b_0, d_n) \end{bmatrix} \qquad (14);$$

$$\tilde{\Psi}_{m \times n, \text{GLO}} = \begin{bmatrix} \tilde{\sigma}_{\text{GLO}}(b_m, d_0) & \cdots & \tilde{\sigma}_{\text{GLO}}(b_m, d_n) \\ \vdots & \ddots & \vdots \\ \tilde{\sigma}_{\text{GLO}}(b_0, d_0) & \cdots & \tilde{\sigma}_{\text{GLO}}(b_0, d_n) \end{bmatrix} \qquad (15);$$

$$\tilde{\Psi}_{m\times n,\text{GAL}} = \begin{bmatrix} \tilde{\sigma}_{\text{GAL}}(b_m, d_0) & \cdots & \tilde{\sigma}_{\text{GAL}}(b_m, d_n) \\ \vdots & \ddots & \vdots \\ \tilde{\sigma}_{\text{GAL}}(b_0, d_0) & \cdots & \tilde{\sigma}_{\text{GAL}}(b_0, d_n) \end{bmatrix} \quad (16);$$

$$\tilde{\Psi}_{m\times n,\text{BDS}} = \begin{bmatrix} \tilde{\sigma}_{\text{BDS}}(b_m, d_0) & \cdots & \tilde{\sigma}_{\text{BDS}}(b_m, d_n) \\ \vdots & \ddots & \vdots \\ \tilde{\sigma}_{\text{BDS}}(b_0, d_0) & \cdots & \tilde{\sigma}_{\text{BDS}}(b_0, d_n) \end{bmatrix} \quad (17).$$

and

Step S709: Perform nonlinear fitting on function relations of a pseudorange/carrier phase measurement error standard deviation with respect to the carrier-to-noise ratio and the altitude angle.

In this embodiment of this application, nonlinear fitting may be performed on a function relation of a pseudorange measurement error standard deviation with respect to the carrier-to-noise ratio CNO and the altitude angle according to the obtained pseudorange measurement error standard deviation grid. Similarly, the foregoing processing is also performed on the carrier phase double-difference residual sequence, and then, a carrier phase measurement error standard deviation grid can be obtained. Nonlinear fitting is performed on a function relation of a carrier phase measurement error standard deviation with respect to the carrier-to-noise ratio CNO and the altitude angle according to the obtained carrier phase measurement error standard deviation grid.

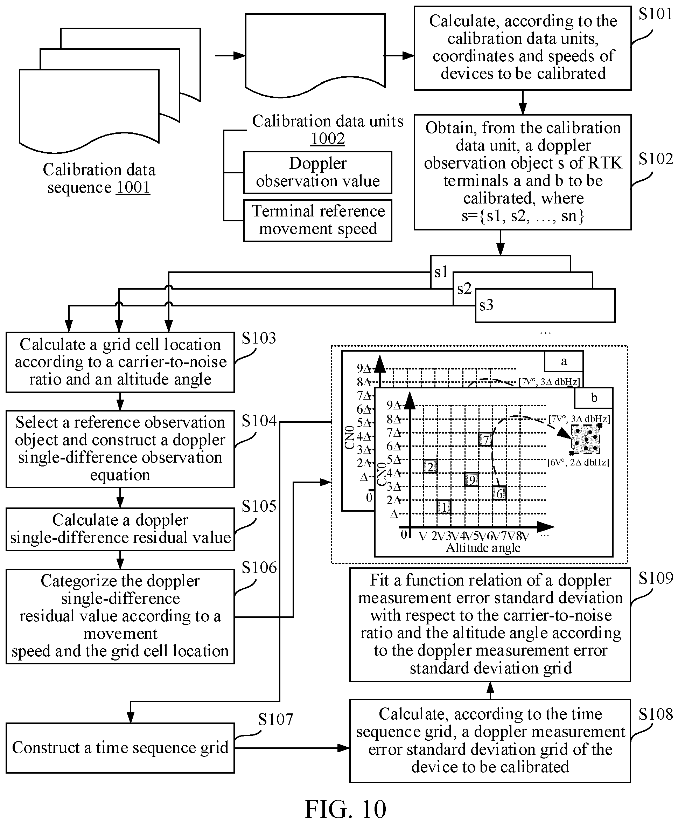

FIG. 10 is a schematic flowchart of a calibration procedure of a doppler observation random error model according to an embodiment of this application. As shown in FIG. 10, a calibration data sequence 1001 is observed observation data. The calibration data sequence 1001 includes calibration data units 1002 (that is, observation subdata) observed in a plurality of epochs. The calibration data unit 1002 includes a doppler observation value and a terminal reference movement speed. After the calibration data units 1002 are obtained, the calibration procedure includes the following steps:

Step S101: Calculate, according to the calibration data units, coordinates and speeds of devices to be calibrated (including an RTK terminal a and an RTK terminal b).

Step S102: Obtain, from the calibration data unit, a doppler observation object S of the device to be calibrated, where S={s1, s2···sm}.

Step S103: Calculate a grid cell location according to a carrier-to-noise ratio and an altitude angle.

Step S104: Select a reference observation object and construct a doppler single-difference observation equation.

Step S105: Calculate a doppler single-difference residual value.

In this embodiment of this application, assuming that the RTK terminal a observes n target observation objects at a moment t, the following doppler observation equation (18) can be constructed:

$$\begin{bmatrix} \tilde{z}_{D1} \\ \tilde{z}_{D2} \\ \vdots \\ \tilde{z}_{Dn} \end{bmatrix} = \begin{bmatrix} \lambda \tilde{D}_a^1 \\ \lambda \tilde{D}_a^2 \\ \vdots \\ \lambda \tilde{D}_a^n \end{bmatrix} - \begin{bmatrix} (v^1 - v_a) \cdot \dfrac{r_a - r^1}{r_a - r^1} + c \cdot \dot{d}t_r - c\dot{d}t^1 \\ (v^2 - v_a) \cdot \dfrac{r_a - r^1}{r_a - r^1} + c \cdot \dot{d}t_r - c\dot{d}t^2 \\ \vdots \\ (v^n - v_a) \cdot \dfrac{r_a - r^1}{r_a - r^1} + c \cdot \dot{d}t_r - c\dot{d}t^n \end{bmatrix} \quad (18),$$

where $\lambda$ is a wavelength of a signal broadcast by the target observation object, $\tilde{D}_a^i$ is a doppler observation value of a target observation object $i$ observed by the RTK terminal a, $i = 1, 2, ..., n$ , $v^i, i = 1, 2, ......, n$ is a running speed of the target observation object $i$ , $v_a$ is a speed of the RTK terminal a, $dt_r$ is a terminal receiver clock drift, and $c$ is a clock drift coefficient; and $c\dot{d}t^i, i = 1, 2, ......, n$ is a clock drift of the target observation object $i$ . With a target observation object 1 as a reference observation object, a doppler single-difference residual sequence may be expressed as the following formula (19):

$$\begin{bmatrix} \Delta \tilde{z}_{D2} \\ \Delta \tilde{z}_{D3} \\ \vdots \\ \Delta \tilde{z}_{Dn} \end{bmatrix} = \begin{bmatrix} \tilde{z}_{D2} - \tilde{z}_{D1} \\ \tilde{z}_{D3} - \tilde{z}_{D1} \\ \vdots \\ \tilde{z}_{Dn} - \tilde{z}_{D1} \end{bmatrix} \qquad (19).$$

Step S106: Categorize the doppler single-difference residual value according to a movement speed and the grid cell location.

Step S107: Construct a time sequence grid.

Step S108: Calculate, according to the time sequence grid, a doppler measurement error standard deviation grid of the device to be calibrated.

In this embodiment of this application, grid processing may be performed on the doppler single-difference

residual sequence $\begin{bmatrix} \Delta \tilde{z}_{D2} \\ \Delta \tilde{z}_{D3} \\ \vdots \\ \Delta \tilde{z}_{Dn} \end{bmatrix}$ by using the following steps: First, assuming that a carrier-to-noise ratio and an altitude angle of a target observation object $i, i = 3, ..., m$ are $CN0_i$ and $el_i$, and a grid cell location of the target observation object

$$p = \left[ \frac{CN0_i}{\Delta} \right], q = \left[ \frac{el_i}{\nabla} \right]$$

$i$ is calculated, that is, , where [·] represents a rounding operation. Then, a doppler single-difference residual value $\Delta \tilde{z}_{Di}$ is categorized into a grid cell. Finally, by analogy, the foregoing processing is also performed on other elements in the doppler single-difference residual sequence.

The foregoing processing is performed on doppler single-difference residual sequences of all moments of the RTK terminal a and the RTK terminal b. In this case, each grid cell corresponds to one doppler single-difference residual sequence, which is expressed as the following formula (20):

$$s_X \left( [a_i, b_i], [c_j, d_j] \right) = \{ z_1, z_2, \cdots, z_f \}, i = 0, 1, ...; j = 0, 1, ...; X = a, b \qquad (20).$$

A standard deviation of the doppler single-difference residual value sequence $s_{SYS}([a_i, b_i], [c_j, d_j])$ corresponding to the grid cell is calculated. That is, refer to the following formula (21):

$$\sigma_X \left( b_i, d_j \right) \approx \sqrt{ \frac{1}{f} \cdot \sum_{k=1}^{f} \left( z_k - \frac{1}{f} \cdot \sum_{m=1}^{f} z_m \right)^2 }, i = 0, 1, ...; j = 0, 1, ...; X = a, b \qquad (21).$$

In this way, the doppler measurement error standard deviation grid, that is, the following formulas (22) to (24), can be obtained:

$$\tilde{\Psi}_{m \times n, a} = \begin{bmatrix} \tilde{\sigma}_a (b_m, d_0) & \cdots & \tilde{\sigma}_a (b_m, d_n) \\ \vdots & \ddots & \vdots \\ \tilde{\sigma}_a (b_0, d_0) & \cdots & \tilde{\sigma}_a (b_0, d_n) \end{bmatrix} \qquad (22);$$

$$\tilde{\Psi}_{m \times n, \mathrm{b}} = \begin{bmatrix} \tilde{\sigma}_b \left( b_m, d_0 \right) & \cdots & \tilde{\sigma}_b \left( b_m, d_n \right) \\ \vdots & \ddots & \vdots \\ \tilde{\sigma}_b \left( b_0, d_0 \right) & \cdots & \tilde{\sigma}_b \left( b_0, d_n \right) \end{bmatrix} \tag{23};$$

$$\tilde{\Psi}_{m \times n} = \frac{1}{2} \left( \tilde{\Psi}_{m \times n, a} + \tilde{\Psi}_{m \times n, b} \right) \tag{24}.$$

and

Step S109: Fit a function relation of a doppler measurement error standard deviation with respect to the carrier-to-noise ratio and the altitude angle according to the doppler measurement error standard deviation grid.

In this embodiment of this application, nonlinear fitting may be performed on the function relation of the doppler measurement error standard deviation with respect to the carrier-to-noise ratio CNO and the altitude angle according to the obtained doppler measurement error standard deviation grid $\tilde{\Psi}_{m \times n}$.

In the error model determining method provided in all embodiments of this application, pseudorange, doppler, and carrier phase observation random error models (that is, a pseudorange error model, a carrier phase error model, and a doppler error model) of any positioning device can be calibrated. This improves accuracy of an observation random error model, thereby effectively improving terminal RTK positioning accuracy and assisting in map lane-level positioning and navigation.

It can be understood that, contents of user information, such as user location information and other related data, are involved in all embodiments of this application. When the embodiments of this application are applied to a specific product or technology, user permission or consent is required, and collection, use, and processing of the related data need to comply with the relevant laws, regulations, and standards of the relevant countries and regions.

The following further describes an exemplary structure of the error model determining apparatus 354 provided in all embodiments of this application and implemented as a software module. In some embodiments, as shown in FIG. 2, the error model determining apparatus 354 includes: a solver module 3541, configured to obtain observation data acquired by at least two devices to be calibrated, and solve a pre-constructed observation equation according to the observation data to obtain a data residual sequence; a grid processing module 3542, configured to perform grid processing on the data residual sequence to obtain a data residual grid; a grid error processing module 3543, configured to perform grid error processing on the data residual grid according to each data residual value in the data residual sequence to obtain a measurement error grid corresponding to the data residual grid; and a nonlinear fitting module 3544, configured to perform nonlinear fitting on the measurement error grid to obtain a data error model of the at least two devices to be calibrated.

In some embodiments, the grid error processing module is further configured to: determine a grid cell corresponding to the each data residual value in the data residual sequence in the data residual grid; perform error calculation on the data residual grid according to the each data residual value in the data residual sequence to obtain an error value of each grid cell corresponding to the data residual sequence in the data residual grid; determine a location of the each grid cell in a pre-constructed grid; and determine the measurement error grid corresponding to the data residual grid according to the error value corresponding to the each grid cell and the location of the each grid cell.

In some embodiments, the grid error processing module is further configured to: perform standard deviation calculation on the data residual grid according to the each data residual value in the data residual sequence to obtain an error standard deviation value of the each grid cell corresponding to the data residual sequence in the data residual grid; determine the error standard deviation value as the error value; categorize, according to the location of the each grid cell, the error standard deviation value corresponding to the each grid cell into the grid cell corresponding to the location to obtain categorized grid cells; and aggregate the categorized grid cells to obtain the measurement error grid.

In some embodiments, the observation data includes an observation carrier-to-noise ratio and an observation altitude angle of any target observation object, and the apparatus further includes: a grid construction module, configured to construct grids in different observation object systems with a carrier-to-noise ratio as a longitudinal coordinate and an altitude angle as a horizontal coordinate according to a preset carrier-to-noise ratio interval and a preset altitude angle interval; and a grid location determining module, configured to: for each of the observation object systems, determine a location of the target observation object corresponding to a target grid cell in the grid according to the observation carrier-to-noise ratio and the observation altitude angle. The grid processing module is further configured to: categorize the each data residual value in the data residual sequence into a target grid cell of a target observation object corresponding to the data residual sequence to obtain the data residual grid, a target grid cell of each target observation object being corresponding to at least a pseudorange double-difference residual sequence, a carrier phase double-difference residual sequence, and a doppler single-difference residual sequence.

In some embodiments, the observation data includes observation subdata of each epoch in a plurality of epochs. The solver module is further configured to: perform, for the observation subdata of the each epoch, weighted least square solution on the observation equation according to the observation subdata to obtain an observation subdata residual value; and aggregate the plurality of obtained observation subdata residual values according to a sequential order of the plurality of epochs to form the data residual sequence.

In some embodiments, the observation subdata includes a pseudorange and a carrier phase, and the observation equation is an RTK observation equation. The solver module further is configured to: perform, for the each epoch, weighted least square solution on the RTK observation equation according to the observation subdata of the epoch to obtain location information and a carrier phase ambiguity floating point solution of any of the devices to be calibrated; perform ambiguity fixation on the carrier phase ambiguity floating point solution to obtain a carrier phase ambiguity fixed value; solve the carrier phase ambiguity fixed value to obtain a fixed solution of the location information; substitute the fixed solution of the location information and the carrier phase ambiguity fixed value into the RTK observation equation to obtain a pseudorange residual value and a carrier phase residual value; and determine the pseudorange residual value and the carrier phase residual value as observation subdata residual values corresponding to the observation subdata.

In some embodiments, the at least two devices to be calibrated include a reference station and a target calibration device. The solver module is further configured to: perform weighted least square solution on the RTK observation equation based on observation subdata of the reference station and the observation subdata of the epoch acquired by the target calibration device to obtain the location information and the carrier phase ambiguity floating point solution of the target calibration device.

In some embodiments, the measurement error grid includes: a pseudorange measurement error standard deviation grid and a carrier phase measurement error standard deviation grid. The grid error processing module is further configured to: determine a first standard deviation of the pseudorange double-difference residual sequence according to each pseudorange double-difference residual value in the pseudorange double-difference residual sequence; determine a second standard deviation of the carrier phase double-difference residual sequence according to each carrier phase double-difference residual value in the carrier phase double-difference residual sequence; determine the pseudorange measurement error standard deviation grid according to the target grid cell of the each target observation object and the first standard deviation; and determine the carrier phase measurement error standard deviation grid according to the target grid cell of the each target observation object and the second standard deviation.

In some embodiments, the observation data includes observation subdata of each epoch in a plurality of epochs. The observation equation is a doppler observation equation. The solver module is further configured to: solve the doppler observation equation according to the observation subdata of the each epoch to obtain a doppler single-difference residual sequence in the epoch; and determine the doppler single-difference residual sequence in the each epoch as the data residual sequence.

In some embodiments, the data residual grid includes an observation data single-difference residual grid. The grid processing module is further configured to: categorize a doppler single-difference residual value in the doppler single-difference residual sequence in the each epoch into a target grid cell of a target observation object corresponding to the doppler single-difference residual sequence to obtain the observation data single-difference residual grid, a target grid cell of each target observation object being corresponding to a doppler single-difference residual sequence.

In some embodiments, the measurement error grid includes: a doppler measurement error standard deviation grid. The grid error processing module is further configured to: determine a third standard deviation of the doppler single-difference residual sequence corresponding to each of the devices to be calibrated according to each doppler single-difference residual value in the doppler single-difference residual sequence; determine, according to the third standard deviation of the each device to be calibrated, a doppler standard deviation grid of the device to be calibrated; and determine the doppler measurement error standard deviation grid according to the doppler standard deviation grids of all the devices to be calibrated.

In some embodiments, the measurement error grid includes: a pseudorange measurement error standard deviation grid, a carrier phase measurement error standard deviation grid, and a doppler measurement error standard deviation grid. The nonlinear fitting module is further configured to: perform nonlinear fitting on the pseudorange measurement error standard deviation grid to obtain a first function relation of a pseudorange measurement error standard deviation with respect to a carrier-to-noise ratio and an altitude angle; perform nonlinear fitting on the carrier phase measurement error standard deviation grid to obtain a second function relation of a carrier phase measurement error standard deviation with respect to the carrier-to-noise ratio and the altitude angle; perform nonlinear fitting on the doppler measurement error standard deviation grid to obtain a third function relation of a doppler measurement error standard deviation with respect to the carrier-to-noise ratio and the altitude angle; and determine the data error model according to the first function relation, the second function relation, and the third function relation.

The foregoing descriptions of the apparatus embodiment are similar to the foregoing descriptions of the method embodiment, and the apparatus embodiment has beneficial effects similar to those of the method embodiment, and therefore is not described in detail. For technical details not disclosed in the apparatus embodiment of this application, refer to descriptions of the method embodiment of this application for understanding.

An embodiment of this application provides a computer program product. The computer program product includes executable instructions. The executable instructions are stored in a computer-readable storage medium. A processor of an electronic device reads the executable instructions from the computer-readable storage medium. The processor executes the executable instructions, so that the electronic device performs the foregoing method in the embodiments of this application.

An embodiment of this application provides a storage medium storing executable instructions. When the executable instructions are executed by a processor, the processor is caused to perform the method provided in the embodiments of this application, for example, the method shown in FIG. 3.

In some embodiments, the storage medium may be a computer-readable storage medium, for example, a memory such as a ferromagnetic random access memory (FRAM), a read-only memory (ROM), a programmable read-only memory (PROM), an erasable programmable read-only memory (EPROM), an electrically erasable programmable read-only memory (EEPROM), a flash memory, a magnetic surface memory, an optical disc, or a compact disc read-only memory (CD-ROM); or may be various devices including one of or any combination of the foregoing memories.

In some embodiments, the executable instruction may be written in the form of a program, software, a software module, a script, or code in any form of programming language (including complied or interpreted languages, or declarative or procedural languages), and may be deployed in any form, including being deployed as a stand-alone program or deployed as a module, a component, a subroutine, or other units suitable environment. In an example, the executable instruction may, but does not necessarily, correspond to a file in a file system, and may be stored in part of a file that holds other programs or data, for example, stored in one or more scripts in a Hyper Text Markup Language (HTML) document, or in a single file specifically used for the program under discussion, or in a plurality of collaborative files (for example, files storing one or more modules, subprograms, or code sections). In an example, the executable instruction may be deployed to be executed on a computing device, or executed on a plurality of computing devices at the same location, or executed on a plurality of computing devices distributed at a plurality of locations and interconnected through a communication network.

The foregoing descriptions are merely embodiments of this application and are not intended to limit the protection scope of this application. Any modification, equivalent replacement, or improvement made without departing from the spirit and scope of this application shall fall within the protection scope of this application.

## Claims

1.   An error model determining method, executable by an error model determining device, and comprising:

obtaining observation data acquired by at least two devices to be calibrated;
solving a pre-constructed observation equation according to the observation data to obtain a data residual sequence;
performing grid processing on the data residual sequence to obtain a data residual grid;
performing grid error processing on the data residual grid according to each data residual value in the data residual sequence to obtain a measurement error grid corresponding to the data residual grid; and
performing nonlinear fitting on the measurement error grid to obtain a data error model of the at least two devices to be calibrated.

2.   The method according to claim 1, wherein the performing grid error processing on the data residual grid according to each data residual value in the data residual sequence to obtain a measurement error grid corresponding to the data residual grid comprises:

determining a grid cell corresponding to the each data residual value in the data residual sequence in the data residual grid;
performing error calculation on the data residual grid according to the each data residual value in the data residual sequence to obtain an error value of each grid cell corresponding to the data residual sequence in the data residual grid;
determining a location of the each grid cell in a pre-constructed grid; and
determining the measurement error grid corresponding to the data residual grid according to the error value corresponding to the each grid cell and the location of the each grid cell.

3.   The method according to claim 2, wherein the performing error calculation on the data residual grid according to the each data residual value in the data residual sequence to obtain an error value of each grid cell corresponding to the data residual sequence in the data residual grid comprises:

performing standard deviation calculation on the data residual grid according to the each data residual value in the data residual sequence to obtain an error standard deviation value of the each grid cell corresponding to the data residual sequence in the data residual grid; and
determining the error standard deviation value as the error value; and
correspondingly, the determining the measurement error grid corresponding to the data residual grid according to the error value corresponding to the each grid cell and the location of the each grid cell comprises:

categorizing, according to the location of the each grid cell, the error standard deviation value corresponding to the each grid cell into the grid cell corresponding to the location to obtain categorized grid cells; and
aggregating the categorized grid cells to obtain the measurement error grid.

4. The method according to claim 3, wherein the observation data comprises an observation carrier-to-noise ratio and an observation altitude angle of any target observation object, and the method further comprises:

constructing grids in different observation object systems with a carrier-to-noise ratio as a longitudinal coordinate and an altitude angle as a horizontal coordinate according to a preset carrier-to-noise ratio interval and a preset altitude angle interval; and
for each of the observation object systems, determining a location of the target observation object corresponding to a target grid cell in the grid according to the observation carrier-to-noise ratio and the observation altitude angle; and
the performing grid processing on the data residual sequence to obtain a data residual grid comprises:
categorizing the each data residual value in the data residual sequence into a target grid cell of a target observation object corresponding to the data residual sequence to obtain the data residual grid, a target grid cell of each target observation object being corresponding to at least a pseudorange double-difference residual sequence, a carrier phase double-difference residual sequence, and a doppler single-difference residual sequence.

5. The method according to claim 1, wherein the observation data comprises observation subdata of each epoch in a plurality of epochs; and
the solving a pre-constructed observation equation according to the observation data to obtain a data residual sequence comprises:

performing, for the observation subdata of the each epoch, weighted least square solution on the observation equation according to the observation subdata to obtain an observation subdata residual value; and
aggregating the plurality of obtained observation subdata residual values according to a sequential order of the plurality of epochs to form the data residual sequence.

6. The method according to claim 5, wherein the observation subdata comprises a pseudorange and a carrier phase, and the observation equation is a real-time kinematic positioning (RTK) observation equation; and
the performing, for the observation subdata of the each epoch, weighted least square solution on the observation equation according to the observation subdata to obtain an observation subdata residual value comprises:

performing, for the each epoch, weighted least square solution on the RTK observation equation according to the observation subdata of the epoch to obtain location information and a carrier phase ambiguity floating point solution of any of the devices to be calibrated;
performing ambiguity fixation on the carrier phase ambiguity floating point solution to obtain a carrier phase ambiguity fixed value;
solving the carrier phase ambiguity fixed value to obtain a fixed solution of the location information;
substituting the fixed solution of the location information and the carrier phase ambiguity fixed value into the RTK observation equation to obtain a pseudorange residual value and a carrier phase residual value; and
determining the pseudorange residual value and the carrier phase residual value as observation subdata residual values corresponding to the observation subdata.

7. The method according to claim 6, wherein the at least two devices to be calibrated comprise a reference station and a target calibration device; and
the performing weighted least square solution on the RTK observation equation according to the observation subdata of the epoch to obtain location information and a carrier phase ambiguity floating point solution of any of the devices to be calibrated comprises:

performing weighted least square solution on the RTK observation equation based on observation subdata of the reference station and the observation subdata of the epoch acquired by the target calibration device to obtain the location information and the carrier phase ambiguity floating point solution of the target calibration device.

8. The method according to claim 4, wherein the measurement error grid comprises: a pseudorange measurement error standard deviation grid and a carrier phase measurement error standard deviation grid; and
the performing grid error processing on the data residual grid according to each data residual value in the data residual sequence to obtain a measurement error grid corresponding to the data residual grid comprises:

> determining a first standard deviation of the pseudorange double-difference residual sequence according to each pseudorange double-difference residual value in the pseudorange double-difference residual sequence;
> determining a second standard deviation of the carrier phase double-difference residual sequence according to each carrier phase double-difference residual value in the carrier phase double-difference residual sequence;
> determining the pseudorange measurement error standard deviation grid according to the target grid cell of the each target observation object and the first standard deviation; and
> determining the carrier phase measurement error standard deviation grid according to the target grid cell of the each target observation object and the second standard deviation.

9. The method according to claim 1, wherein the observation data comprises observation subdata of each epoch in a plurality of epochs; and the observation equation is a doppler observation equation; and
the solving a pre-constructed observation equation according to the observation data to obtain a data residual sequence comprises:

> solving the doppler observation equation according to the observation subdata of the each epoch to obtain a doppler single-difference residual sequence in the epoch; and
> determining the doppler single-difference residual sequence in the each epoch as the data residual sequence.

10. The method according to claim 9, wherein the data residual grid comprises an observation data single-difference residual grid; and the performing grid processing on the data residual sequence to obtain a data residual grid comprises:

> categorizing a doppler single-difference residual value in the doppler single-difference residual sequence in the each epoch into a target grid cell of a target observation object corresponding to the doppler single-difference residual sequence to obtain the observation data single-difference residual grid,
> a target grid cell of each target observation object being corresponding to a doppler single-difference residual sequence.

11. The method according to claim 10, wherein the measurement error grid comprises: a doppler measurement error standard deviation grid; and
the performing grid error processing on the data residual grid according to each data residual value in the data residual sequence to obtain a measurement error grid corresponding to the data residual grid comprises:

> determining a third standard deviation of the doppler single-difference residual sequence corresponding to each of the devices to be calibrated according to each doppler single-difference residual value in the doppler single-difference residual sequence;
> determining, according to the third standard deviation of the each device to be calibrated, a doppler standard deviation grid of the device to be calibrated; and
> determining the doppler measurement error standard deviation grid according to the doppler standard deviation grids of all the devices to be calibrated.

12. The method according to claim 1, wherein the measurement error grid comprises: a pseudorange measurement error standard deviation grid, a carrier phase measurement error standard deviation grid, and a doppler measurement error standard deviation grid; and
the performing nonlinear fitting on the measurement error grid to obtain a data error model of the at least two devices to be calibrated comprises:

performing nonlinear fitting on the pseudorange measurement error standard deviation grid to obtain a first function relation of a pseudorange measurement error standard deviation with respect to a carrier-to-noise ratio and an altitude angle;

performing nonlinear fitting on the carrier phase measurement error standard deviation grid to obtain a second function relation of a carrier phase measurement error standard deviation with respect to the carrier-to-noise ratio and the altitude angle;

performing nonlinear fitting on the doppler measurement error standard deviation grid to obtain a third function relation of a doppler measurement error standard deviation with respect to the carrier-to-noise ratio and the altitude angle; and

determining the data error model according to the first function relation, the second function relation, and the third function relation.

13. An error model determining apparatus, comprising:

a solver module, configured to obtain observation data acquired by at least two devices to be calibrated, and solve a pre-constructed observation equation according to the observation data to obtain a data residual sequence;

a grid processing module, configured to perform grid processing on the data residual sequence to obtain a data residual grid;

a grid error processing module, configured to perform grid error processing on the data residual grid according to each data residual value in the data residual sequence to obtain a measurement error grid corresponding to the data residual grid; and

a nonlinear fitting module, configured to perform nonlinear fitting on the measurement error grid to obtain a data error model of the at least two devices to be calibrated.

14. An electronic device, comprising:
a memory, configured to store executable instructions; and a processor, configured to execute the executable instructions stored in the memory to implement the error model determining method according to any one of claims 1 to 12.

15. A computer-readable storage medium, storing executable instructions, and configured to cause a processor to execute the executable instructions to implement the error model determining method according to any one of claims 1 to 12.

16. A computer program product, comprising executable instructions, the executable instructions, when executed by a processor, implementing the error model determining method according to any one of claims 1 to 12.

10

Network 200

Observation data

Data error model

100-1

100-2

Observation data

Data error model

Server 300

FIG. 1A

Satellite 2

Satellite 1

Satellite 3

Observation
data

201

FIG. 1B

Error model
determining
device

Memory 350

Operating system 351

Network interface 320

Network communication module 352

Processor 310

Input processing module 353

Error model determining apparatus 354

340

User interface 330

Output device 331

Input device 332

Solver module 3541

Grid processing module 3542

Grid error processing module 3543

Nonlinear fitting module 3544

FIG. 2

Obtain observation data acquired by at least two devices to be calibrated, and solve a pre-constructed observation equation according to the observation data to obtain a data residual sequence — S301

Perform grid processing on the data residual sequence to obtain a data residual grid — S302

Perform grid error processing on the data residual grid according to each data residual value in the data residual sequence to obtain a measurement error grid corresponding to the data residual grid — S303

Perform nonlinear fitting on the measurement error grid to obtain a data error model of the at least two devices to be calibrated — S304

FIG. 3

S401

Obtain observation data acquired by at least two devices to be calibrated

S402

Perform, for observation subdata of each epoch, weighted least square solution on the observation equation according to the observation subdata to obtain an observation subdata residual value

S404

Construct grids in different observation object systems with a carrier-to-noise ratio as a longitudinal coordinate and an altitude angle as a horizontal coordinate according to a preset carrier-to-noise ratio interval and a preset altitude angle interval

S403

Aggregate a plurality of obtained observation subdata residual values according to a sequential order of a plurality of epochs to form a data residual sequence

S405

For each of the observation object systems, determine a location of a target observation object corresponding to a target grid cell in a grid according to an observation carrier-to-noise ratio and an observation altitude angle

S406

Categorize each observation subdata residual value into a target grid cell of a corresponding target observation object to obtain a data residual grid

S407

Determine a first standard deviation of a pseudorange double-difference residual sequence according to each pseudorange double-difference residual value in the pseudorange double-difference residual sequence; and determine a second standard deviation of a carrier phase double-difference residual sequence according to each carrier phase double-difference residual value in the carrier phase double-difference residual sequence

S408

Determine a pseudorange measurement error standard deviation grid according to a target grid cell of each target observation object and the first standard deviation

S410

Determine a carrier phase measurement error standard deviation grid according to a target grid cell of each target observation object and the second standard deviation

S409

Perform nonlinear fitting on the pseudorange measurement error standard deviation grid to correspondingly obtain a pseudorange error model of the at least two devices to be calibrated

S411

Perform nonlinear fitting on the carrier phase measurement error standard deviation grid to correspondingly obtain a carrier phase error model of the at least two devices to be calibrated

FIG. 4

| Obtain observation data acquired by at least two devices to be calibrated | S501 |

| Solve a doppler observation equation according to observation subdata of each epoch to obtain a doppler single-difference residual sequence in the epoch | S502 |

| Determine the doppler single-difference residual sequence in the each epoch as a data residual sequence | S503 |

| Categorize a doppler single-difference residual value in the doppler single-difference residual sequence in the each epoch into a target grid cell of a corresponding target observation object to obtain an observation data single-difference residual grid | S504 |

| Determine, according to each doppler single-difference residual value in the doppler single-difference residual sequence, a third standard deviation of the doppler single-difference residual sequence corresponding to each of the devices to be calibrated | S505 |

| Determine, according to the third standard deviation of the each device to be calibrated, a doppler standard deviation grid of the device to be calibrated | S506 |

| Determine a doppler measurement error standard deviation grid according to the doppler standard deviation grids of all the devices to be calibrated | S507 |

| Perform nonlinear fitting on the doppler measurement error standard deviation grid to correspondingly obtain a doppler error model of the at least two devices to be calibrated | S508 |

FIG. 5

S602

Pseudorange observation data

Carrier phase observation data

Doppler observation data

Signal power splitter 61

S601

S601

RTK terminal 62

RTK terminal 63

Observation data of RTK terminal

Construct a zero baseline — S603

RTK solution — S604

Pseudorange/carrier phase double-difference residual sequence, and doppler single-difference residual sequence — S605

Perform grid processing to construct a time sequence grid — S606

Calculate, according to the time sequence grid, pseudorange/carrier phase/doppler observation data measurement error variances and standard deviation grids of the RTK terminals to be calibrated — S607

Perform nonlinear fitting on function relations of pseudorange/carrier phase/doppler measurement error standard deviations with respect to a carrier-to-noise ratio $CN0$ and an altitude angle — S608

GPS

GLO

GAL

BDS

FIG. 6

**Calibration data sequence 71**

Calibration data units 72
- Pseudorange/Carrier phase of RTK terminals a and b
- Precise coordinates of RTK terminals a and b

**S701** Calculate, according to the calibration data units, precise coordinates of devices to be calibrated

**S702** Search the calibration data units for the same target observation object S observed by the devices to be calibrated, where S={s1,s2,...,sm}.

s1
s2
s3
...

**S703** Calculate a grid cell location according to a carrier-to-noise ratio and an altitude angle

**S704** Construct a zero baseline, and perform RTK solution

**S705** Pseudorange/carrier phase double-difference residual value

**S706** Categorize the pseudorange/ carrier phase double-difference residual value according to an observation object system and the grid cell location

GPS
GLO
GAL
BDS

**S707** Construct a time sequence grid

**S708** Calculate, according to the time sequence grid, pseudorange/carrier phase measurement error variance and standard deviation grids of the RTK terminals a and b to be calibrated

**S709** Perform nonlinear fitting on function relations of a pseudorange/carrier phase measurement error standard deviation with respect to the carrier-to-noise ratio and the altitude angle

FIG. 7

FIG. 8

FIG. 9

Calculate, according to the calibration data units, coordinates and speeds of devices to be calibrated — S101

Calibration data sequence 1001

Calibration data units 1002

Doppler observation value

Terminal reference movement speed

Obtain, from the calibration data unit, a doppler observation object s of RTK terminals a and b to be calibrated, where s={s1, s2, ..., sn} — S102

s1

s2

s3

...

Calculate a grid cell location according to a carrier-to-noise ratio and an altitude angle — S103

Select a reference observation object and construct a doppler single-difference observation equation — S104

Calculate a doppler single-difference residual value — S105

Categorize the doppler single-difference residual value according to a movement speed and the grid cell location — S106

Construct a time sequence grid — S107

Fit a function relation of a doppler measurement error standard deviation with respect to the carrier-to-noise ratio and the altitude angle according to the doppler measurement error standard deviation grid — S109

Calculate, according to the time sequence grid, a doppler measurement error standard deviation grid of the device to be calibrated — S108

FIG. 10

## INTERNATIONAL SEARCH REPORT

| International application No. |
|---|
| **PCT/CN2022/128156** |

### A. CLASSIFICATION OF SUBJECT MATTER

G01S 19/39(2010.01)i; G01S 19/44(2010.01)i; G06F 17/15(2006.01)i; G06F 30/20(2020.01)i

According to International Patent Classification (IPC) or to both national classification and IPC

### B. FIELDS SEARCHED

Minimum documentation searched (classification system followed by classification symbols)

G02S 19/-; G06F 17/-; G06F 30/-

Documentation searched other than minimum documentation to the extent that such documents are included in the fields searched

Electronic data base consulted during the international search (name of data base and, where practicable, search terms used)

WPABSC; CNTXT; OETXT; CNABS; CNKI; WPABS; ENTXT; DWPI; ENTXTC; VEN: 误差模型, 残差, 观测方程, 残差网格, 误差网格, 拟合, 标定, error model, calibrat+, residual sequence, observation equation, residual grid, error grid, nonlinear fitting

### C. DOCUMENTS CONSIDERED TO BE RELEVANT

| Category* | Citation of document, with indication, where appropriate, of the relevant passages | Relevant to claim No. |
|---|---|---|
| PX | CN 114397680 A (TENCENT TECHNOLOGY SHENZHEN CO., LTD.) 26 April 2022 (2022-04-26) description, paragraphs 32-261, and figures 1-10 | 1-16 |
| X | CN 112433236 A (TENCENT TECHNOLOGY SHENZHEN CO., LTD.) 02 March 2021 (2021-03-02) description, paragraphs 64-341, and figures 1-17 | 1-16 |
| A | CN 112902989 A (TENCENT TECHNOLOGY SHENZHEN CO., LTD.) 04 June 2021 (2021-06-04) entire document | 1-16 |
| A | CN 104880717 A (JIAXING MICROELECTRONICS AND SYSTEMS ENGINEERING CENTER, CHINESE ACADEMY OF SCIENCES) 02 September 2015 (2015-09-02) entire document | 1-16 |
| A | CN 108957490 A (SOUTHEAST UNIVERSITY et al.) 07 December 2018 (2018-12-07) entire document | 1-16 |
| A | CN 107576975 A (BEIHANG UNIVERSITY) 12 January 2018 (2018-01-12) entire document | 1-16 |

☑ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **04 December 2022** | **16 December 2022** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT

| | International application No. |
|---|---|
| | **PCT/CN2022/128156** |

### C. DOCUMENTS CONSIDERED TO BE RELEVANT

| Category* | Citation of document, with indication, where appropriate, of the relevant passages | Relevant to claim No. |
|---|---|---|
| A | CN 109459778 A (SOUTHEAST UNIVERSITY et al.) 12 March 2019 (2019-03-12)<br>entire document | 1-16 |
| A | CN 101802643 A (LEICA GEOSYSTEMS AG.) 11 August 2010 (2010-08-11)<br>entire document | 1-16 |
| A | US 2011018763 A1 (DENSO CORPORATION) 27 January 2011 (2011-01-27)<br>entire document | 1-16 |

Form PCT/ISA/210 (second sheet) (January 2015)

## INTERNATIONAL SEARCH REPORT
### Information on patent family members

International application No.

**PCT/CN2022/128156**

| Patent document cited in search report | | | Publication date (day/month/year) | Patent family member(s) | | | Publication date (day/month/year) |
|---|---|---|---|---|---|---|---|
| CN | 114397680 | A | 26 April 2022 | None | | | |
| CN | 112433236 | A | 02 March 2021 | CN | 112433236 | B | 18 May 2021 |
| | | | | WO | 2022161229 | A1 | 04 August 2022 |
| CN | 112902989 | A | 04 June 2021 | CN | 112902989 | B | 16 July 2021 |
| CN | 104880717 | A | 02 September 2015 | CN | 104880717 | B | 17 May 2017 |
| CN | 108957490 | A | 07 December 2018 | CN | 108957490 | B | 12 August 2022 |
| CN | 107576975 | A | 12 January 2018 | CN | 107576975 | B | 30 July 2019 |
| CN | 109459778 | A | 12 March 2019 | None | | | |
| CN | 101802643 | A | 11 August 2010 | EP | 2040090 | A1 | 25 March 2009 |
| | | | | AU | 2008300961 | A1 | 26 March 2009 |
| | | | | EP | 2191290 | A1 | 02 June 2010 |
| | | | | CA | 2699388 | A1 | 26 March 2009 |
| | | | | US | 2010207817 | A1 | 19 August 2010 |
| | | | | WO | 2009036860 | A1 | 26 March 2009 |
| | | | | AU | 2008300961 | B2 | 03 February 2011 |
| | | | | US | 8072373 | B2 | 06 December 2011 |
| | | | | EP | 2191290 | B1 | 19 December 2012 |
| | | | | CA | 2699388 | C | 30 April 2013 |
| | | | | CN | 101802643 | B | 24 July 2013 |
| US | 2011018763 | A1 | 27 January 2011 | JP | 2011013189 | A | 20 January 2011 |
| | | | | JP | 5460148 | B2 | 02 April 2014 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210051258